# FASCICULE DE BREVET EUROPEEN

(11) **EP 3 811 402 B1**
(45) Date de publication et mention de la délivrance du brevet: **31.07.2024**
(21) Numéro de dépôt: 19745693.2
(22) Date de dépôt: 19.06.2019
(51) Int. Cl.: H01L 21/78, H01L 21/02, H10N 30/073

(54) **PROCÉDÉ DE TRANSFERT DE COUCHE(S) DE MATÉRIAU DEPUIS UN PREMIER SUBSTRAT SUR UN DEUXIÈME SUBSTRAT**
VERFAHREN ZUR ÜBERTRAGUNG VON MINDESTENS EINER MATERIALSCHICHT VON EINEM ERSTEN SUBSTRAT ZU EINEM ZWEITEN SUBSTRAT
METHOD FOR TRANSFERRING AT LEAST ONE LAYER OF MATERIAL FROM A FIRST SUBSTRATE TO A SECOND SUBSTRATE

(30) Priorité: 22.06.2018 FR 1855594
(43) Date de publication de la demande: 28.04.2021
(73) Titulaire: Commissariat à l'énergie atomique et aux énergies alternatives, 75015 Paris (FR)
(72) Inventeur: LE RHUN, Gwenaël, 38054 GRENOBLE CEDEX 09 (FR); DIEPPEDALE, Christel, 38054 GRENOBLE CEDEX 09 (FR); FANGET, Stéphane, 38054 GRENOBLE CEDEX 09 (FR)
(74) Mandataire: Brevalex
(86) Numéro de dépôt international: PCT/FR2019/051503
(87) Numéro de publication internationale: WO 2019/243744

(56) Documents cités:
- EP-A2- 2 690 198
- WO-A1-2017/018222
- JP-A- 2014 187 094
- US-A1- 2003 064 569
- US-A1- 2011 204 750

## Description

### DOMAINE TECHNIQUE ET ART ANTÉRIEUR

L'invention porte sur un procédé de transfert de couche(s) de matériau depuis un premier substrat sur un deuxième substrat. L'invention s'applique notamment au domaine de la réalisation de composants MEMS (microsystème électromécanique) et/ou NEMS (nanosystème électromécanique) et/ou de composants microélectroniques, le procédé de transfert de couche(s) étant mis en oeuvre lors de la réalisation de tels composants. L'invention s'applique avantageusement à la réalisation de transducteurs piézoélectriques et/ou pyroélectriques et/ou ferroélectriques, ou de composants comprenant des condensateurs de type MIM (métal - isolant - métal) et/ou coplanaires.

Lors de la réalisation de composants MEMS et/ou NEMS, ou de composants microélectroniques, des étapes de dépôt de couches, minces ou épaisses, sur un substrat sont mises en oeuvre. Le substrat sur lequel ces couches sont déposées peut comporter du semi-conducteur, comme par exemple du silicium, ou bien du verre, du saphir, ou du métal comme par exemple de l'aluminium, ou peut correspondre à un substrat comprenant au moins un matériau polymère.

Cependant, dans certains cas, la température de dépôt et/ou de recuit de ces couches n'est pas compatible avec le substrat sur lequel ces couches sont déposées. Par exemple, lorsque des composants de type CMOS sont présents sur le substrat, la réalisation de couches de matériaux sur un tel substrat ne doit pas impliquer la mise en oeuvre d'étapes nécessitant une température supérieure ou égale à environ 400°C. Selon un autre exemple, de telles contraintes peuvent découler de la présence de matériaux dont les propriétés changent avec le budget thermique, par exemple à cause d'une diffusion, ou de la génération de contraintes, se produisant aux températures de dépôt et/ou de recuit requises. Selon un autre exemple, lorsque le substrat utilisé correspond à un substrat comprenant au moins un matériau polymère, les températures de dépôt et/ou de recuit de couches sur un tel substrat ne doivent pas dépasser environ 150°C.

Pour répondre à ce problème, différents procédés de transfert de couches de matériaux depuis un substrat donneur, sur lequel la ou les couches à transférer sont réalisées initialement, sur un substrat receveur ont été développés. Etant donné que les étapes de dépôt et/ou de recuit nécessaires à la réalisation de cette ou ces couches sont mises en oeuvre avant le transfert de la ou des couches sur le substrat receveur, le ou les matériaux du substrat receveur et/ou du ou des éléments déjà présents sur le substrat receveur ne sont pas impactés par les températures mises en jeu lors du dépôt et/ou du recuit de la ou des couches sur le substrat donneur.

Un de ces procédés de transfert consiste à former une interface de clivage par implantation ionique dans le substrat donneur. Le substrat donneur, sur lequel la ou les couches à transférer ont été réalisées, est ensuite solidarisé au substrat receveur. Une séparation des deux substrats est ensuite réalisée, au niveau de l'interface de clivage formée dans le substrat donneur, par traitement thermique. Un tel procédé de transfert permet toutefois de ne transférer que des couches d'épaisseur relativement faible, au plus d'environ 1 micron d'épaisseur. De plus, les étapes d'implantation ionique et de traitement thermique devant être mises en oeuvre ne sont parfois pas compatibles avec les éléments et/ou matériaux présents sur l'un et/ou l'autre des substrats.

Un autre procédé de transfert consiste à former la ou les couches souhaitées sur le substrat donneur, à reporter ensuite sur le substrat receveur l'ensemble formé de la ou des couches souhaitées et du substrat donneur, puis à graver le substrat donneur depuis sa face arrière (face opposée à celle sur laquelle se trouve(nt) la ou les couches à transférer). L'inconvénient d'un tel procédé est que le substrat donneur est détruit et qu'il ne peut donc pas être réutilisé pour réaliser un autre transfert de couche(s).

Les documents JP 2014 187094 A et US 2003/064569 A1 divulguent tels processus de transfert et de délaminage des couches de matériaux.

### EXPOSÉ DE L'INVENTION

Un but de la présente invention est de proposer un procédé de transfert d'au moins une couche de matériau depuis un premier substrat sur un deuxième substrat ne présentant pas les inconvénients des procédés de transfert de l'art antérieur, c'est-à-dire qui ne soit pas limité sur la nature et l'épaisseur de la ou des couches transférées, et qui permet de réutiliser le substrat donneur sur lequel la ou les couches à transférer sont réalisées initialement.

Pour cela, la présente invention propose un procédé de transfert d'au moins une couche de matériau depuis un premier substrat sur un deuxième substrat, comportant au moins :
- réalisation, sur une face du premier substrat, de première et deuxième couches de séparation disposées l'une contre l'autre telles que la première couche de séparation soit disposée entre le premier substrat et la deuxième couche de séparation ;
- réalisation, sur la deuxième couche de séparation, de ladite au moins une couche de matériau à transférer ;
- solidarisation de ladite au moins une couche de matériau à transférer au deuxième substrat, formant un empilement de différents matériaux ;
- séparation mécanique au niveau d'une interface entre les première et deuxième couches de séparation, telle que la première couche de séparation reste solidaire du premier substrat et que la deuxième couche de séparation reste solidaire de ladite au moins une couche de matériau à transférer;
dans lequel les matériaux de l'empilement sont choisis tels que l'interface entre les première et deuxième couches de séparation correspond à celle, parmi toutes les interfaces de l'empilement, ayant la plus faible force d'adhérence, et dans lequel le procédé comporte, entre l'étape de réalisation des première et deuxième couches de séparation et l'étape de solidarisation, la mise en oeuvre d'au moins une étape réduisant une force d'adhérence initiale de l'interface entre les première et deuxième couches de séparation.

La force d'adhérence à l'interface entre les première et deuxième couches de séparation est réduite en mettant en oeuvre une étape spécifique, comme par exemple la formation de cavités à cette interface.

Ce procédé a également pour avantage d'être compatible avec n'importe quelle épaisseur de couche(s), c'est-à-dire une ou plusieurs couches minces et/ou épaisses, à transférer d'un substrat à l'autre.

De plus, à l'issue de la séparation mécanique à l'interface entre les première et deuxième couches de séparation, le premier substrat n'est pas détruit et peut être réutilisé pour réaliser un nouveau transfert de couche(s) depuis le premier substrat sur un autre deuxième substrat ou sur le même deuxième substrat intégrant la ou les couches précédemment reportées.

L'une des première et deuxième couches de séparation peut comporter au moins du SiOz et/ou du nitrure de silicium (tel que du SiN et/ou du Si₃N₄), et l'autre des première et deuxième couches de séparation peut comporter au moins un métal noble.

L'interface au niveau de laquelle la séparation mécanique est réalisée peut être définie au préalable par un choix judicieux des matériaux des première et deuxième couches de séparation engendrant naturellement une faible force d'adhérence à cette interface. En utilisant d'un côté un métal noble et de l'autre du SiOz et/ou du nitrure de silicium pour former les première et deuxième couches de séparation, une faible force d'adhérence est obtenue à l'interface de ces deux couches de séparation, sans avoir à mettre en oeuvre d'étape spécifique. Ainsi, après avoir solidarisé les deux substrats l'un à l'autre, la séparation mécanique réalisée au niveau de l'interface entre les première et deuxième couches de séparation ne dégrade pas les autres couches car c'est l'interface entre les première et deuxième couches de séparation qui présente la plus faible force d'adhérence parmi toutes les interfaces de l'empilement obtenu en solidarisant les premier et deuxième substrats entre eux.

L'utilisation d'un métal noble pour former l'une des première et deuxième couches de séparation a pour avantage d'éviter une oxydation de cette couche de séparation au contact de l'autre couche de séparation qui comporte le SiOz et/ou le nitrure de silicium, notamment lorsque la ou les couches de matériaux à transférer sont réalisées en impliquant des budgets thermiques importants, par exemple à des températures supérieures à environ 450°C, comme c'est le cas lorsqu'un ou plusieurs matériaux de structure cristalline pérovskite sont déposés (PZT, BST, BCTZ, PMN-PT, KNN, NBT-BT, etc.).

Le métal utilisé pour former l'une des première et deuxième couches de séparation peut correspondre à un métal résistant à l'oxydation.

Dans l'ensemble du document, le terme « sur » est utilisé sans distinction de l'orientation dans l'espace de l'élément auquel ce rapporte ce terme. Par exemple, dans la caractéristique « sur une face du premier substrat », cette face du premier substrat n'est pas nécessairement orientée vers le haut mais peut correspondre à une face orientée selon n'importe quelle direction. En outre, la disposition d'un premier élément sur un deuxième élément doit être comprise comme pouvant correspondre à la disposition du premier élément directement contre le deuxième élément, sans aucun élément intermédiaire entre les premier et deuxième éléments, ou bien comme pouvant correspondre à la disposition du premier élément sur le deuxième élément avec un ou plusieurs éléments intermédiaires disposés entre les premier et deuxième éléments.

L'expression « toutes les interfaces de l'empilement » désigne toutes les interfaces formées entre deux couches successives (disposées l'une directement contre l'autre) de l'empilement.

La couche de séparation comportant du SiOz et/ou du nitrure de silicium peut correspondre à une couche de SiO₂ ou de nitrure de silicium, ou à un empilement de SiO₂ et de nitrure de silicium.

Le métal noble correspond à l'un ou plusieurs des matériaux suivants : platine (Pt), or (Au), argent (Ag), rhodium (Rh), osmium (Os), palladium (Pd), ruthénium (Ru), iridium (Ir).

Lorsque le métal noble est destiné à être exposé à de forts budgets thermiques, par exemple jusqu'à une température égale à environ 850°C, ce métal noble comporte avantageusement du platine et/ou du palladium. Lorsque le métal noble est destiné à être exposé à des températures moins importantes, comme par exemple des températures inférieures ou égales à environ 400°C, les autres métaux nobles (Au, Ag, Rh, Os, Ru, Ir) peuvent être utilisés pour former cette couche de métal noble.

La force d'adhérence de l'interface entre les première et deuxième couches de séparation peut être inférieure ou égale à environ 1,5 J/m², ou de préférence inférieure ou égale à environ 1 J/m². A titre d'exemple, la force d'adhérence entre les première et deuxième couches de séparation avec l'une comprenant du SiO₂ et l'autre du platine est égale à environ 1 J/m².

La force d'adhérence entre deux couches de matériaux peut être mesurée par la méthode dite d'insertion de lame décrite par exemple dans le document W. P. Mazsara et al., « Bonding of silicon wafers for silicon-on-insulator », Journal of Applied Physics 64, p. 4943, 1988).

Après la séparation au niveau de l'interface entre les première et deuxième couches de séparation, la surface libre de la couche de séparation qui comporte le métal noble a une très faible rugosité. Il n'est donc pas nécessaire de mettre en oeuvre un polissage après avoir mis en oeuvre l'étape de séparation mécanique.

Ce procédé peut s'appliquer au transfert de n'importe quelle couche ou empilement de couches déposé(e) sur du SiOz et/ou du nitrure de silicium (celui de ladite une des première et deuxième couches de séparation) ou sur un métal noble (celui de ladite autre des première et deuxième couches de séparation).

Le premier substrat peut comporter du semi-conducteur, par exemple du silicium.

Le deuxième substrat peut comporter du semi-conducteur, par exemple du silicium, ou du verre, du saphir, du métal ou un matériau polymère.

De manière avantageuse, le métal noble peut comporter du platine.

Ladite au moins une étape réduisant la force d'adhérence initiale de l'interface entre les première et deuxième couches de séparation peut comporter la mise en oeuvre d'au moins un traitement thermique à une température modifiant une contrainte du métal noble. Un tel traitement thermique permet de modifier la contrainte du métal noble, ce changement de contrainte permettant un décollement plus facile lors de la mise en oeuvre de l'étape de séparation à l'interface entre les première et deuxième couches de séparation. Par exemple, lorsque le métal noble comporte ou correspond à du platine, le dépôt de ce métal génère une contrainte en compression dans le métal déposé. Le traitement thermique qui est mis en oeuvre à une température par exemple supérieure ou égale à 250°C, ou supérieure ou égale à 300°C, modifie cette contrainte en compression qui devient une contrainte en tension.

L'étape de la solidarisation peut être mise en oeuvre :
- par l'intermédiaire d'une couche adhésive réalisée sur ladite au moins une couche de matériau à transférer ou sur le deuxième substrat, ou
- par thermocompression entre une première couche métallique de collage, réalisée sur ladite au moins une couche de matériau à transférer, et une deuxième couche métallique de collage réalisée sur le deuxième substrat, ou
- par collage direct, ou collage moléculaire, entre une première couche de collage, réalisée sur ladite au moins une couche de matériau à transférer, et une deuxième couche de collage réalisée sur le deuxième substrat.

Lorsque l'étape de solidarisation est mise en oeuvre par l'intermédiaire de la couche adhésive réalisée sur ladite au moins une couche de matériau à transférer ou sur le deuxième substrat, il est possible d'avoir une ou plusieurs autres couches de matériaux présentes entre la couche adhésive et ladite au moins une couche de matériau à transférer ou entre la couche adhésive et le deuxième substrat. En outre, la couche adhésive peut comporter au moins une colle à base de polymère.

Lorsque l'étape de solidarisation est mise en oeuvre par thermocompression entre les première et deuxième couches métalliques de collage, il est possible d'avoir une ou plusieurs autres couches de matériaux présentes entre la première couche métallique de collage et ladite au moins une couche de matériau à transférer et/ou entre la deuxième couche métallique de collage et le deuxième substrat. En outre, les première et deuxième couches métalliques de collage peuvent comporter avantageusement du cuivre et/ou de l'or. La thermocompression peut être mise en oeuvre à une température inférieure ou égale à environ 400°C, voire inférieure à environ 150°C.

Lorsque l'étape de solidarisation est mise en oeuvre par collage direct, ou collage moléculaire, entre les première et deuxième couches de collage, il est possible d'avoir une ou plusieurs autres couches de matériaux présentes entre la première couche de collage et ladite au moins une couche de matériau à transférer et/ou entre la deuxième couche de collage et le deuxième substrat.

Ladite au moins une couche de matériau à transférer peut comporter au moins une couche de matériau pyroélectrique et/ou piézoélectrique et/ou ferroélectrique et/ou diélectrique. Dans une telle configuration, la couche de matériau pyroélectrique et/ou piézoélectrique et/ou ferroélectrique et/ou diélectrique qui est transférée peut servir à la réalisation de composants, par exemple de type MEMS et/ou NEMS, et tels que des actionneurs et/ou des capteurs (ou plus généralement tout transducteur) piézoélectriques, des dispositifs pyroélectriques, des dispositifs de récupération d'énergie vibratoire, des mémoires ferroélectriques, des capacités à forte densité, des capacités RF (radiofréquence), ou des LEDs. L'empilement ainsi transféré sur le deuxième substrat peut servir à la réalisation d'un empilement de transduction électromécanique. En variante, ladite au moins une couche de matériau à transférer peut comporter au moins un composant fonctionnel tel qu'au moins l'un de ceux décrits ci-dessus et réalisés avant la solidarisation de ladite au moins une couche de matériau à transférer (dans laquelle ce ou ces composants sont réalisés) au deuxième substrat.

La couche de matériau pyroélectrique et/ou piézoélectrique et/ou ferroélectrique et/ou diélectrique peut notamment servir à réaliser au moins un empilement de type MIM d'un composant réalisé à partir des couches de matériaux transférées sur le deuxième substrat. Dans ce cas, une couche électriquement conductrice, comprenant par exemple de l'or, est avantageusement présente sur le deuxième substrat avant l'étape de solidarisation, ce qui permet la réalisation de capacités RF ayant un facteur qualité important.

Ce procédé est particulièrement avantageux lorsque le matériau pyroélectrique et/ou piézoélectrique et/ou ferroélectrique et/ou diélectrique comporte du plomb, comme par exemple lorsque ce matériau correspond à du PZT (Titano-Zirconate de Plomb) ou un matériau de la même famille que le PZT, car il permet dans ce cas de s'affranchir des contraintes liées à l'intégration de ce matériau comportant le plomb, telles que le budget thermique nécessaire à son dépôt (qui n'est pas compatible avec un substrat comprenant des composants CMOS, ou un substrat de verre ou encore un substrat comprenant un polymère). Par exemple, lorsque le matériau pyroélectrique et/ou piézoélectrique et/ou ferroélectrique et/ou diélectrique correspond à un matériau à structure cristalline pérovskite comme par exemple du PZT, la cristallisation / densification de ce matériau nécessite d'atteindre des températures supérieures à environ 500°C, voire 700°C, ce qui n'est pas compatible avec un substrat comprenant des composants CMOS, ou un substrat de verre ou encore un substrat polymère.

En outre, il est possible de prévoir sur le deuxième substrat une couche de SiN qui permet d'ajuster une contrainte dans un empilement d'un composant de type MEMS et qui ne doit pas être contaminé par du plomb diffusé depuis le matériau piézoélectrique et/ou pyroélectrique et/ou ferroélectrique et/ou diélectrique, au risque d'engendrer des décollements pendant le dépôt de ce matériau. Cela évite également l'ajout de couches servant de barrières de diffusion comprenant par exemple du SiO₂ et qui complexifient l'empilement final de matériaux (par exemple, le SiO₂ rend la gestion globale des contraintes plus difficile en raison de sa contrainte compressive).

Le procédé peut être tel que :
- le matériau pyroélectrique et/ou piézoélectrique et/ou ferroélectrique et/ou diélectrique comporte du plomb, et peut correspondre à du PZT ;
- ladite une des première et deuxième couches de séparation comporte du SiO₂;
- ladite au moins une étape réduisant la force d'adhérence initiale de l'interface entre les première et deuxième couches de séparation comporte la mise en oeuvre d'au moins un traitement thermique formant, à l'interface entre les première et deuxième couches de séparation, un alliage de plomb et de SiO₂ en phase liquide, puis d'un refroidissement formant des cavités à l'interface entre les première et deuxième couches de séparation.

De telles cavités contribuent, seules ou en complément des matériaux choisis pour former les première et deuxième couches de séparation, à l'obtention de la faible force d'adhérence à l'interface entre les première et deuxième couches de séparation.

Ladite au moins une couche à transférer peut comporter au moins une première couche d'électrode telles que la couche de matériau pyroélectrique et/ou piézoélectrique et/ou ferroélectrique et/ou diélectrique soit disposée entre la première couche d'électrode et la deuxième couche de séparation. Cette première couche d'électrode peut avantageusement servir pour former les électrodes des composants réalisés ensuite à partir des couches transférées sur le deuxième substrat. En variante, lorsque l'étape de solidarisation comporte une thermocompression entre deux couches métalliques de collage, ces deux couches métalliques de collage peuvent servir de couche d'électrode.

La deuxième couche de séparation peut comporter le métal noble. Ainsi, outre son rôle pour l'obtention d'une faible force d'adhérence entre les première et deuxième couches de séparation, cette deuxième couche de séparation peut être conservée, après l'étape de séparation mécanique, pour servir de couche d'électrode pour les composants réalisés ensuite à partir des couches transférées sur le deuxième substrat.

Ladite au moins une couche de matériau à transférer peut comporter au moins une deuxième couche d'électrode disposée entre la couche de matériau pyroélectrique et/ou piézoélectrique et/ou ferroélectrique et/ou diélectrique et la deuxième couche de séparation. Une telle deuxième couche d'électrode peut servir pour former les électrodes des composants réalisés ensuite à partir des couches transférées sur le deuxième substrat

La première couche électriquement conductrice et/ou la deuxième couche électriquement conductrice peut comporter au moins un métal et/ou au moins un oxyde métallique.

En variante, ladite au moins une couche de matériau à transférer peut comporter au moins une première couche de matériau pyroélectrique et/ou piézoélectrique et/ou ferroélectrique et/ou diélectrique, et le procédé peut comprendre en outre, avant l'étape de solidarisation, la réalisation d'au moins une deuxième couche de matériau pyroélectrique et/ou piézoélectrique et/ou ferroélectrique et/ou diélectrique et d'au moins une troisième couche d'électrode disposée entre le deuxième substrat et la deuxième couche de matériau pyroélectrique et/ou piézoélectrique et/ou ferroélectrique et/ou diélectrique. Cette variante est avantageusement mise en oeuvre lorsque le procédé de transfert sert à la réalisation de composants transducteurs réalisant à la fois la fonction d'actionneur et la fonction de capteur.

Le procédé peut comprendre en outre :
- avant l'étape de solidarisation, la réalisation de cavités dans le deuxième substrat, à travers une face du deuxième substrat sur laquelle de ladite au moins une couche de matériau à transférer est solidarisée, et/ou
- après l'étape de solidarisation, la réalisation de cavités dans le deuxième substrat, à travers une face opposée à celle sur laquelle ladite au moins une couche de matériau à transférer est solidarisée.

De telles cavités peuvent servir à former des membranes de composants à partir de la ou des couches transférées sur le deuxième substrat, notamment pour la réalisation de transducteur électromécanique, notamment piézoélectrique de type PMUT (Transducteur Ultrasonore Micro-usiné Piézoélectrique) ou des dispositifs de récupération d'énergie.

Le deuxième substrat peut comporter au moins un matériau polymère, et l'étape de solidarisation peut être mise en oeuvre à une température inférieure ou égale à environ 150°C. Ainsi, grâce au transfert de couches mis en oeuvre après leur réalisation sur le premier substrat, les étapes réalisant ces couches sur le premier substrat ne sont pas limitées par la température maximale supportée par le substrat polymère. A titre d'exemples non limitatifs, une solidarisation à une température inférieure à environ 150°C peut correspondre à un collage par thermocompression réalisé entre deux couches métalliques relativement fines, par exemple deux couches d'or d'épaisseur égale à environ 50 nm, ou bien un collage par l'intermédiaire d'une couche de colle comprenant un matériau polymère, ou encore un collage moléculaire oxyde - oxyde.

Le procédé peut comprendre en outre, après l'étape de séparation mécanique, une étape de gravure de la deuxième couche de séparation.

Le procédé peut comporter en outre, entre l'étape de réalisation de ladite au moins une couche de matériau à transférer et l'étape de solidarisation de ladite au moins une couche de matériau à transférer au deuxième substrat, une étape de réalisation de composants fonctionnels de type MEMS et/ou NEMS et/ou microélectroniques à partir de ladite au moins une couche de matériau à transférer.

Après l'étape de séparation mécanique, les précédentes étapes du procédé de transfert peuvent être répétées chacune au moins une fois pour transférer au moins une autre couche de matériau depuis le premier substrat sur ladite au moins une couche de matériau.

L'invention concerne également un procédé de réalisation de composants de type MEMS et/ou NEMS et/ou microélectroniques, comprenant la mise en oeuvre d'un procédé de transfert tel que décrit ci-dessus, puis la réalisation des composants à partir du deuxième substrat et de ladite au moins une couche de matériau à transférer.

Les composants réalisés peuvent être des transducteurs piézoélectriques et/ou des composants pyroélectriques et/ou ferroélectriques. Dans ce cas, le procédé mis en oeuvre permet d'éviter une gravure profonde de tout le substrat par la face arrière ou un meulage d'un substrat SOI. Selon une autre possibilité, les composants réalisés peuvent comporter des condensateurs de type MIM et/ou coplanaires.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1D représentent les étapes d'un procédé de transfert d'au moins une couche de matériau selon un premier mode de réalisation ;
- les figures 2A à 2D représentent les étapes d'un procédé de transfert d'au moins une couche de matériau selon un deuxième mode de réalisation ;
- les figures 3A à 3D représentent les étapes d'un procédé de transfert d'au moins une couche de matériau selon un troisième mode de réalisation ;
- la figure 4 représente un empilement de matériaux formé au cours d'un procédé de transfert d'au moins une couche de matériau selon un quatrième mode de réalisation ;
- la figure 5 représente un empilement de matériaux formé au cours d'un procédé de transfert d'au moins une couche de matériau selon une variante du quatrième mode de réalisation ;
- les figures 6A à 6C représentent les étapes d'un procédé de transfert d'au moins une couche de matériau selon un cinquième mode de réalisation ;
- les figures 7A à 7C représentent les étapes d'un procédé de transfert d'au moins une couche de matériau selon une variante du cinquième mode de réalisation ;
- les figures 8A à 8C représentent les étapes d'un procédé de transfert d'au moins une couche de matériau selon un sixième mode de réalisation ;
- les figures 9A et 9B représentent des dispositifs réalisés à partir de couches transférées par un procédé de transfert d'au moins une couche de matériau selon le sixième mode de réalisation ;
- les figures 10A à 10F représentent les étapes d'un procédé de transfert d'au moins une couche de matériau selon un septième mode de réalisation ;
- la figure 11 représente une structure obtenue en mettant en oeuvre un procédé de transfert d'au moins une couche de matériau selon un huitième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

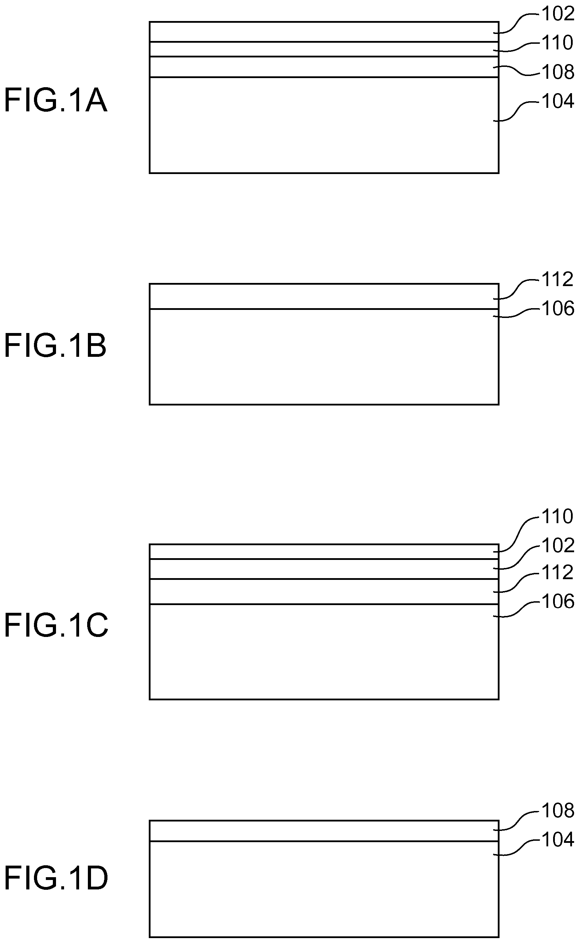

On se réfère tout d'abord aux figures 1A à 1D qui représentent les étapes d'un procédé de transfert d'au moins une couche de matériau selon un premier mode de réalisation.

Comme représenté sur la figure 1A, la référence 102 désigne la ou les couches de matériaux destinées à être transférées depuis un premier substrat 104, également appelé substrat donneur et qui correspond au substrat sur lequel la ou les couches 102 sont initialement réalisées, sur un deuxième substrat 106, également appelé substrat receveur, visible sur la figure 1B.

La ou chacune des couches de matériaux à transférer 102 peut être mince ou épaisse, et a par exemple une épaisseur comprise entre environ 1 nm et 1 mm. La nature du ou des matériaux de cette ou ces couches 102 dépend des composants destinés à être réalisés à partir de cette ou ces couches 102. Ce procédé peut s'appliquer au transfert de tout type de matériau.

Selon un autre exemple de réalisation, un ou plusieurs composants microélectroniques tels que des transistors, des diodes électroluminescentes, etc. peuvent être réalisés, préalablement au transfert de la ou des couches 102 sur le deuxième substrat 106, dans la ou les couches 102.

Le premier substrat 104 correspond ici à un substrat de semi-conducteur comprenant par exemple du silicium, et dont l'épaisseur est par exemple comprise entre environ 100 µm et 1 mm.

Le deuxième substrat 106 comporte au moins un matériau correspondant par exemple à un semi-conducteur tel que du silicium, ou du verre, du saphir, du métal ou bien un matériau polymère. Dans le cas d'un deuxième substrat 106 souple / flexible, celui-ci peut être disposé sur un support rigide pendant le transfert de la ou des couches sur celui-ci. L'épaisseur du deuxième substrat 106 est par exemple égale à plusieurs centaines de microns. Lorsque le deuxième substrat 106 correspond à un substrat en matériau polymère, son épaisseur est par exemple comprise entre environ 1 µm et 1 mm.

Une interface de faible force d'adhérence est formée entre la ou les couches 102 et le premier substrat 104. Dans ce premier mode de réalisation, cette interface est formée grâce à une première couche de séparation 108 comprenant ici au moins du SiOz et/ou du nitrure de silicium tel que du SiN et/ou du Si₃N₄, et une deuxième couche de séparation 110 comprenant au moins un métal noble. L'interface de faible force d'adhérence correspond à l'interface entre ces deux couches de séparation 108, 110, et est obtenue grâce la nature des matériaux des couches de séparation 108, 110 qui n'adhèrent que faiblement l'un à l'autre. Le matériau de la première couche de séparation 108 peut correspondre avantageusement à du SiO₂. La première couche de séparation 108 est par exemple réalisée par oxydation thermique de la face supérieure du premier substrat 104. L'épaisseur de la première couche de séparation 108 est par exemple comprise entre environ 1 nm et 20 µm.

Le métal noble de la deuxième couche de séparation 110 comporte au moins l'un des éléments suivants : platine, or, argent, rhodium, osmium, palladium, ruthénium, iridium. L'épaisseur de la deuxième couche de séparation 110 est par exemple comprise entre environ 1 nm et 200 nm.

Dans le premier mode de réalisation décrit ici, une couche adhésive 112 est disposée sur le deuxième substrat 106. Selon un exemple de réalisation particulier, il est possible que des éléments fonctionnels soient présents sur le deuxième substrat 106, par exemple des composants électroniques. Dans ce cas, la couche adhésive 112 recouvre ces éléments fonctionnels. A titre d'exemple, la couche adhésive 112 peut correspondre à une couche de colle polymère ou un film sec adhésif, dont l'épaisseur est par exemple comprise entre environ 100 nm et 1 mm.

L'ensemble formé du premier substrat 104, des couches de séparation 108, 110 et de la ou des couches 102 est solidarisé sur le deuxième substrat 106 tel que la ou les couches 102 soient disposées contre la couche adhésive 112, c'est-à-dire entre les deux substrats 104, 106. Au sein de l'empilement ainsi obtenu, l'interface de faible force d'adhérence formée entre les couches de séparation 108, 110 correspond, parmi toutes les interfaces de l'empilement, à celle qui présente la plus faible force d'adhérence entre deux couches successives de l'empilement.

Une séparation mécanique est ensuite réalisée au niveau de cette interface de faible force d'adhérence entre les couches de séparation 108, 110. Cette séparation mécanique est par exemple réalisée en introduisant une lame entre les deux wafers. A l'issue de cette séparation mécanique, l'empilement restant conservé comporte le deuxième substrat 106 sur lequel la ou les couches 102 sont solidarisées par l'intermédiaire de la couche adhésive 112. La deuxième couche de séparation 110, qui peut être conservée ou bien retirée après l'étape de séparation, est disposée sur la ou les couches 102 (voir figure 1C).

La figure 1D représente l'ensemble formé du premier substrat 104 et de la première couche de séparation 108, séparé des autres couches. Ce premier substrat 104 peut être réutilisé pour réaliser le transfert d'une ou plusieurs autres couches 102 sur un autre deuxième substrat 106 ou sur le même substrat 106 intégrant déjà une ou plusieurs couches précédemment reportées.

Dans le premier mode de réalisation décrit en lien avec les figures 1A à 1D, la première couche de séparation 108 comporte du SiOz et/ou du nitrure de silicium et la deuxième couche de séparation 110 comporte le métal noble. Cela peut être avantageux lorsque le matériau de la deuxième couche de séparation 110 est utilisé ensuite pour la réalisation de composants à partir des couches reportées sur le deuxième substrat 106. Selon une variante de réalisation, il est toutefois possible que la première couche de séparation 108 comporte le métal noble et que la deuxième couche de séparation 110 comporte le SiOz et/ou le nitrure de silicium.

Dans le premier mode de réalisation décrit ci-dessus, la solidarisation entre la ou les couches 102 et le deuxième substrat 106 est assurée par la couche adhésive 112. En variante, il est possible que cette solidarisation soit réalisée d'une autre façon.

Par exemple, il est possible de réaliser un collage direct, ou collage moléculaire, entre deux couches de collage. Chacune de ces deux couches de collage a des propriétés adaptées à un tel collage direct : très faible rugosité, matériau adapté, etc. Ces deux couches de collage correspondent par exemple à des couches de SiO₂, de Si ou encore de SiN, et comportent par exemple chacune une épaisseur comprise entre environ 1 nm et 1 mm.

Selon un autre exemple de réalisation, la solidarisation entre la ou les couches 102 et le deuxième substrat 106 peut être assurée par un collage par thermocompression. Dans ce cas, deux couches métalliques de collage sont réalisées, l'une sur la ou les couches 102 et l'autre sur le deuxième substrat 106. Ces couches métalliques de collage correspondent par exemple à des couches comprenant du cuivre ou de l'or, et dont l'épaisseur est par exemple comprise entre environ 1 nm et 100 µm.

Tout autre moyen de collage peut également être envisagé pour réaliser la solidarisation entre la ou les couches 102 et le deuxième substrat 106, du moment que cette solidarisation ne forme pas une interface ayant une force d'adhérence plus faible que celle formée entre les couches de séparation 108, 110.

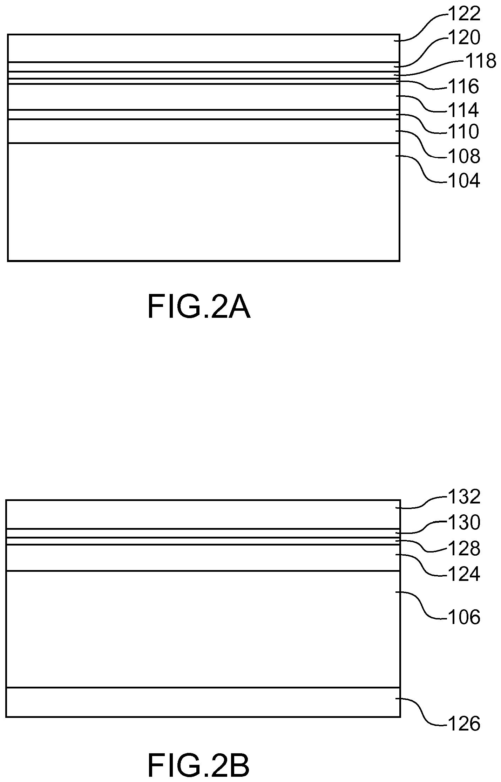

Les figures 2A à 2D représentent les étapes d'un procédé de transfert d'au moins une couche de matériau selon un deuxième mode de réalisation.

Dans ce deuxième mode de réalisation, l'élément à transférer du premier substrat 104 au deuxième substrat 106 correspond à un empilement de plusieurs couches destinées à servir à la réalisation de dispositifs piézoélectriques et/ou pyroélectriques et/ou ferroélectriques et/ou diélectriques. Cet empilement de plusieurs couches à transférer est formé sur la première couche de séparation 108, et comporte :
- la deuxième couche de séparation 110, qui comprend par exemple du platine et dont l'épaisseur est par exemple égale à environ 100 nm ;
- une couche 114 de matériau piézoélectrique et/ou pyroélectrique et/ou ferroélectrique et/ou diélectrique, comprenant par exemple du PZT et/ou de l'AIN et/ou du KNN ((KₓNa₁₋ₓ)NbO₃), et dont l'épaisseur est par exemple comprise entre environ 1 nm et 100 µm et ici égale à environ 500 nm.
- une couche d'accroche 116 optionnelle, qui comprend par exemple du ruthénium et/ou du tungstène et/ou du chrome et/ou du titane et/ou du TiOz, et dont l'épaisseur est par exemple comprise entre environ 0 nm et 10 nm ;
- une couche d'électrode 118, qui comporte un matériau électriquement conducteur, par exemple le même métal que celui de la deuxième couche de séparation 110, ici du platine et/ou du ruthénium et/ou de l'iridium, et dont l'épaisseur est par exemple comprise entre environ 1 nm et 500 nm et ici égale à celle de la deuxième couche de séparation 110, c'est-à-dire environ 100 nm.

La présence ou non de la couche d'accroche 116 est fonction notamment de l'adhérence de la couche d'électrode 118 sur la couche 114.

Dans cet empilement, la deuxième couche de séparation 110 est configurée pour former, dans les dispositifs qui seront réalisés à partir de l'empilement de couches transférées sur le deuxième substrat 106, une des électrodes se trouvant d'un côté des portions issues de la couche 114 de chacun des dispositifs. La couche d'électrode 118, qui est ici métallique, est destinée à former l'autre des deux électrodes de ces dispositifs.

Une couche 120 optionnelle formant une barrière de diffusion, comprenant par exemple du RuO₂ et/ou du Ni et/ou du TiN et/ou du WN et dont l'épaisseur est par exemple égale à environ 60 nm ou plus généralement comprise entre environ 0 nm et 100 nm, est disposée sur la couche d'électrode 118. La présence ou non de la couche 120 est fonction du budget thermique auquel l'empilement est soumis après le report.

Une première couche métallique de collage 122, adaptée pour la mise en oeuvre d'un collage par thermocompression, est disposée sur la couche barrière 120. La couche barrière 120 est configurée pour former une barrière de diffusion entre la couche d'électrode 118 et la première couche métallique de collage 122 et éviter une éventuelle diffusion (en fonction du budget thermique appliqué) du métal issu de la première couche métallique de collage 122 dans la couche d'électrode 118 lors de la solidarisation avec le deuxième substrat 106.

Comme dans le premier mode de réalisation, la première couche de séparation 108 comporte du SiO₂ et/ou du nitrure de silicium tel que du SiN et/ou du Si₃N₄, et a par exemple une épaisseur égale à environ 500 nm. L'interface de faible force adhérence est ici formée, comme dans le premier mode de réalisation, entre la première couche de séparation 108 et la deuxième couche de séparation 110 en raison de la faible force d'adhérence obtenue entre le SiOz et/ou le nitrure de silicium de la première couche de séparation 108 et le métal noble de la deuxième couche de séparation 110.

L'empilement représenté sur la figure 2A est par exemple obtenu en mettant en oeuvre les étapes suivantes :
- oxydation thermique du premier substrat 104, formant la première couche de séparation 108 au niveau d'une face avant du premier substrat 104 ;
- désoxydation (optionnelle) de la face arrière du premier substrat 104 (retirant l'oxyde formé sur la face arrière du premier substrat 104 lors de l'étape précédente d'oxydation) ;
- dépôt, par exemple PVD (dépôt physique en phase vapeur), du métal noble de la deuxième couche de séparation 110 sur la première couche de séparation 108 ;
- dépôt, par exemple par un procédé sol-gel, du matériau pyroélectrique et/ou piézoélectrique et/ou ferroélectrique et/ou diélectrique de la couche 114 ;
- dépôts successifs des métaux des couches 116, 118, 120 et 122.

L'empilement obtenu à l'issue de ces étapes est représenté sur la figure 2A.

Parallèlement à la réalisation des différentes couches précédemment décrites sur le premier substrat 104, le deuxième substrat 106 est également préparé pour le transfert de l'empilement de couches 110, 114, 116, 118, 120, 122.

Comme représenté sur la figure 2B, le deuxième substrat 106 est recouvert, du côté de ses faces avant et arrière, par des couches d'oxyde 124, 126 par exemple chacune similaire à la première couche de séparation 108. Dans l'exemple de réalisation décrit ici, chacune des couches d'oxyde 124, 126 comporte du SiOz et une épaisseur par exemple égale à environ 500 nm.

La couche d'oxyde 124, qui correspond à celle se trouvant du côté où le premier substrat 104 est destiné à être reporté, forme une couche d'isolation électrique entre le deuxième substrat 106 et les autre couches se trouvant sur la couche 124. La couche d'isolation 124 est recouverte d'une couche d'accroche 128 comportant par exemple un métal tel que du titane, du chrome, du tungstène ou du ruthénium, et dont l'épaisseur est par exemple égale à environ 20 nm ou plus généralement comprise entre environ 1 nm et 100 nm. Une autre couche 130 est disposée sur la couche 128 et comporte par exemple du nitrure, ici du TiN et/ou du WN, et a une épaisseur égale à environ 60 nm ou plus généralement comprise entre environ 1 nm et 100 nm.

En variante, il est possible que la couche d'oxyde 124 ne soit pas présente entre le deuxième substrat 106 et la couche d'accroche 128. En effet, il peut être avantageux de ne pas avoir de SiO₂ dans l'empilement formant un transducteur piézoélectrique pour faciliter la gestion des contraintes, car la contrainte compressive du SiOz peut rendre plus complexe la gestion globale des contraintes dans les structures piézoélectriques.

Une deuxième couche métallique de collage 132 est disposée sur la couche 130. Chacune des première et deuxième couches métalliques de collage 122, 132 comporte un matériau, ici un métal, adapté pour la mise en oeuvre d'une thermocompression entre ces deux couches. Dans l'exemple de réalisation particulier décrit ici, les première et deuxième couches métalliques de collage 122, 132 comportent du cuivre et ont chacune une épaisseur égale à environ 500 nm. Selon un autre exemple de réalisation, les première et deuxième couches métalliques de collage 122, 132 peuvent comporter de l'or, et peuvent chacune avoir une épaisseur égale à environ 50 nm.

La couche 130 forme ici une barrière de diffusion permettant d'éviter une diffusion du métal de la deuxième couche métallique de collage 132 dans les couches 128, 124 et dans le deuxième substrat 106. Cette couche 130 est toutefois optionnelle.

Dans l'exemple de réalisation décrit ici, la face arrière du deuxième substrat 106 est recouverte de la couche d'oxyde 126. En variante, il est possible de supprimer cette couche d'oxyde 126 est réalisant une désoxydation de la face arrière du deuxième substrat 106, comme pour le premier substrat 104.

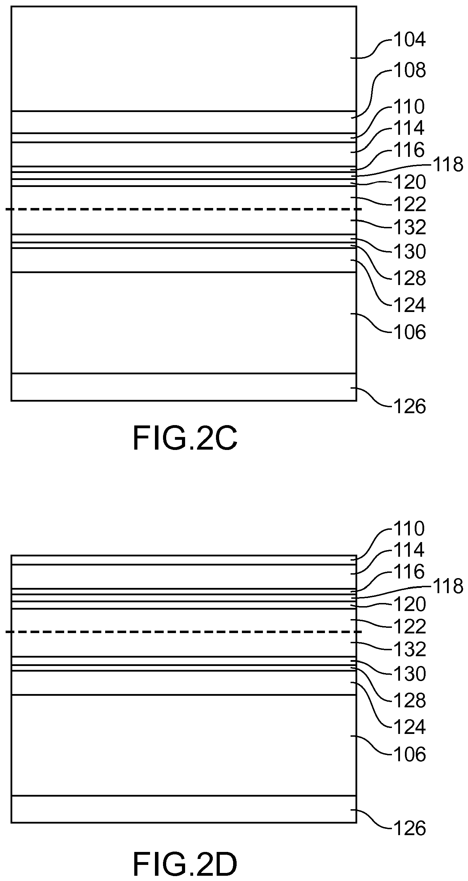

Comme représenté sur la figure 2C, le premier substrat 104 et les couches formées sur celui-ci sont transférés sur le deuxième substrat 106 en réalisant un collage par thermocompression entre les deux couches métalliques de collage 122, 132. Ce collage par thermocompression est par exemple mis en oeuvre à une température comprise entre environ 20°C et 400°C, en appliquant une force de compression comprise entre environ 1 kN et 50 kN, et pendant une durée par exemple comprise entre environ 1 min et 30 min. La force et la durée avec lesquelles le collage par thermocompression est mis en oeuvre sont fonction notamment des épaisseurs des couches métalliques à coller. Les paramètres de mise en oeuvre de cette thermocompression sont adaptés notamment en fonction des propriétés des couches métalliques de collage 122, 132.

Une séparation mécanique des deux substrats 104, 106 est ensuite réalisée au niveau de l'interface de faible force d'adhérence entre les couches de séparation 108, 110, comme dans le premier mode de réalisation précédemment décrit. A l'issue de cette séparation mécanique, l'empilement restant conservé comporte le deuxième substrat 106, et les couches 124, 128, 130, 132, 122, 120, 118, 116, 114 et 110 disposées sur le deuxième substrat 106 (voir figure 2D).

Le premier substrat 104 et la première couche de séparation 108 sont ainsi séparés des autres couches. Ce premier substrat 104 peut être réutilisé pour réaliser le transfert d'autres couches sur un autre deuxième substrat 106.

Les différents exemples et variantes précédemment décrits en lien avec le premier mode de réalisation peuvent s'appliquer à ce deuxième mode de réalisation.

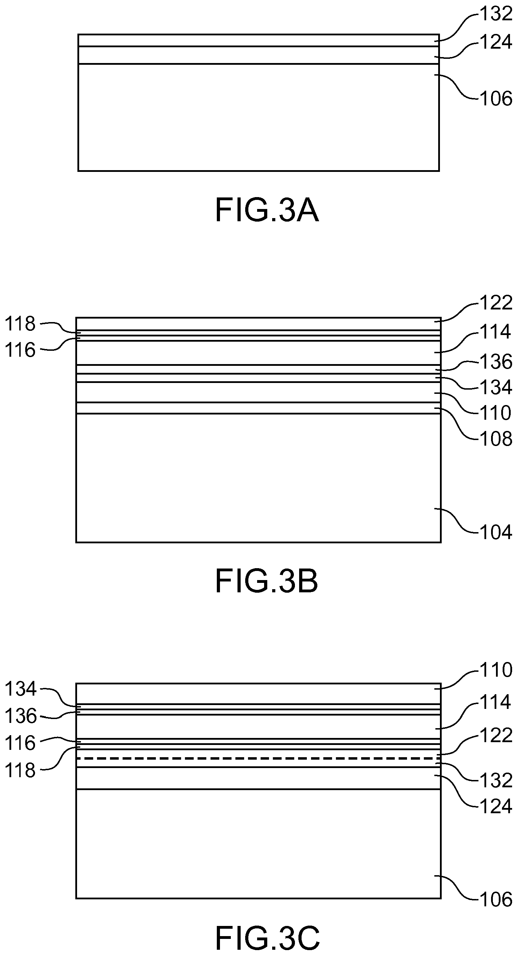

Les figures 3A à 3D représentent les étapes d'un procédé de transfert d'au moins une couche de matériau selon un troisième mode de réalisation.

La figure 3A montre le deuxième substrat 106 sur lequel plusieurs couches vont être transférées. Le substrat 106 comporte sa face avant sur laquelle est disposée la couche d'isolation 124. La deuxième couche métallique de collage 132, qui correspond ici à une couche d'or d'épaisseur égale à environ 50 nm, est disposée sur la couche d'isolation 124.

La figure 3B montre le premier substrat 104 qui comporte les couches à transférer. La première couche de séparation 108, correspondant par exemple à une couche de platine, est disposée sur la face avant du premier substrat 104. La deuxième couche de séparation 110 est disposée sur la première couche de séparation 108, et correspond ici à une couche de SiO₂.

Les couches à transférer sur le deuxième substrat 106 sont disposées sur la deuxième couche de séparation 110. Ces couches correspondent à :
- une couche d'accroche 134, comprenant par exemple du TiO₂, assurant une bonne adhérence entre la deuxième couche de séparation 110 et une couche d'électrode 136 qui comporte ici du platine et est destinée à former une première électrode des dispositifs qui seront réalisés à partir des couches transférées sur le deuxième substrat 106 ;
- la couche 114 de matériau piézoélectrique et/ou pyroélectrique et/ou ferroélectrique et/ou diélectrique, qui comporte par exemple du PZT
- la couche d'accroche 116 optionnelle et la couche d'électrode 118 ;
- la première couche métallique de collage 122.

Comme dans le deuxième mode de réalisation précédemment décrit, un collage par thermocompression est ensuite réalisé entre les première et deuxième couches métalliques de collage 122, 132.

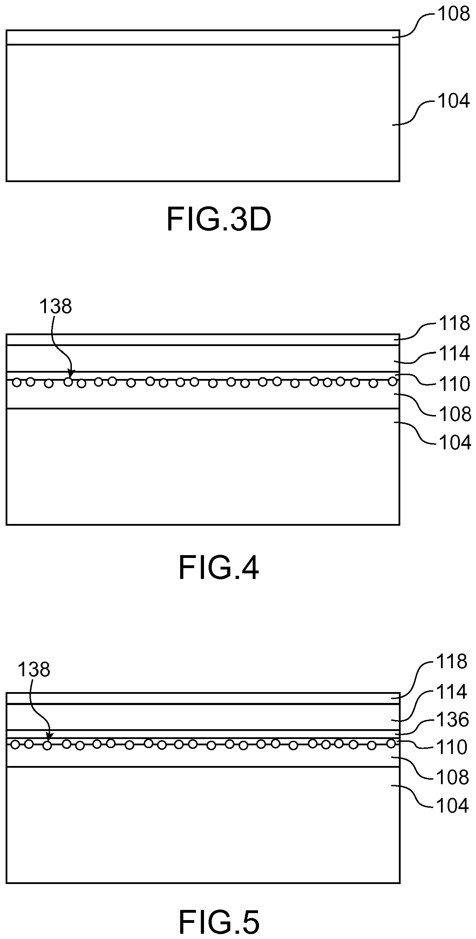

Une séparation mécanique est ensuite réalisée au niveau de l'interface de faible force d'adhérence formée entre les couches de séparation 108, 110, comme dans les précédents modes de réalisation. La figure 3C montre le deuxième substrat 106 sur lequel les différentes couches ont été transférées, et la figure 3D montre le premier substrat 104 restant sur lequel la première couche de séparation 108 est conservée. La deuxième couche de séparation 110 qui se trouve au sommet des couches transférées sur le deuxième substrat 106 peut être supprimée.

Les différents exemples et variantes de réalisation précédemment décrits en lien avec les précédents modes de réalisation peuvent s'appliquer à ce troisième mode de réalisation.

Dans les trois modes de réalisation précédemment décrits, l'interface de faible force d'adhérence est formée grâce aux propriétés intrinsèques des matériaux des couches de séparation 108, 110, du fait que du SiOz et/ou du nitrure de silicium et un métal noble adhérent peu l'un à l'autre.

En variante, il est possible que la faible force d'adhérence de l'interface entre le substrat donneur (premier substrat 104) et la ou les couches à transférer sur le substrat receveur (deuxième substrat 106) soit obtenue grâce à la mise en oeuvre d'au moins une étape spécifique dégradant volontairement les propriétés d'adhérence de cette interface et réduisant la force d'adhérence à cette interface entre les matériaux des première et deuxième couches de séparation 108, 110. A titre d'exemple, lors du dépôt de la couche 114 sur la deuxième couche de séparation 110, il est possible de mettre en oeuvre un traitement thermique faisant diffuser des atomes de plomb issus du PZT de la couche 114 vers le SiO₂ de la première couche de séparation 108, à travers la deuxième couche de séparation 110 qui comporte par exemple du platine. Avec un tel traitement thermique, par exemple mis en oeuvre à une température supérieure ou égale à environ 700°C, un mélange SiOz + Pb en phase liquide se forme à l'interface entre les première et deuxième couches de séparation 108, 110. Lorsque la température descend, des cavités se créent alors à cette interface, dans la couche formée du mélange de SiO₂ et de plomb.

La figure 4 représente la structure obtenue pendant la mise en oeuvre du procédé de transfert de couche(s) selon un quatrième mode de réalisation. Cette structure comporte le premier substrat 104 sur lequel sont disposées les couches 108, 110, 114 et 118, et dont l'interface formée entre les couches de séparation 108, 110 est dégradée par des cavités 138 créées suite à la diffusion du plomb du PZT de la couche 114 dans le SiO₂ de la première couche de séparation 108. Ces cavités 138 réduisent l'adhérence entre les couches de séparation 108, 110.

Cette dégradation, ou réduction, de la force d'adhérence de l'interface entre les couches de séparation 108, 110 peut donc être réalisée lorsque les propriétés intrinsèques des matériaux utilisés pour ces couches de séparation 108, 110 n'engendrent pas, sans intervention supplémentaire, la formation d'une interface de faible force d'adhérence.

La figure 5 représente une telle variante dans laquelle la deuxième couche de séparation 110 correspond ici à une couche de TiO₂. L'épaisseur de cette deuxième couche de séparation 110 est par exemple égale à environ 20 nm. La référence 136 désigne une couche d'électrode destinée à former une électrode des composants qui seront réalisés ensuite, et qui comporte par exemple du platine. Dans cette configuration, la force d'adhérence entre le TiO₂ de la deuxième couche de séparation 110 et le platine de la couche d'électrode 136 ainsi que celle entre le SiO₂ de la première couche de séparation 108 et le TiO₂ de la deuxième couche de séparation 110 ne sont pas faibles par rapport à celles des autres interfaces de cet empilement. Grâce au traitement thermique mis en oeuvre après le dépôt de la couche 114, la diffusion du plomb issu du PZT de la couche 114 jusqu'à l'interface entre les couches de séparation 108, 110 et la formation des cavités 138 à cette interface permettent de lui conférer une faible force d'adhérence. En variante, la deuxième couche de séparation peut comporter du ZrO₂ ou bien encore du ZnO ou du Ta₂O₅.

Cette dégradation volontaire de l'interface de séparation entre les premier et deuxième substrats est mise en oeuvre pour tous les modes de réalisation précédemment décrits.

Une autre possibilité pour dégrader ou réduire la force d'adhérence de l'interface entre les couches de séparation 108, 110 consiste à mettre en oeuvre un traitement thermique à une température modifiant une contrainte du métal noble de l'une des deux couches de séparation 108, 110. En considérant les exemples précédemment décrits où la deuxième couche de séparation 110 comporte un métal noble, et notamment du platine, qui comporte une contrainte en compression générée lors de son dépôt, la mise en oeuvre d'un traitement thermique à une température par exemple supérieure ou égale à 250°C, voire supérieure ou égale à 300°C, modifie cette contrainte qui devient une contrainte en tension. Ce changement de contrainte permet un décollement plus facile lors de la mise en oeuvre de l'étape de séparation à l'interface entre les première et deuxième couches de séparation 108, 110.

Dans les deuxième et troisième modes de réalisation précédemment décrits, la couche 114 comporte avantageusement un matériau pyroélectrique et/ou piézoélectrique et/ou ferroélectrique et/ou diélectrique et est disposée entre deux couches d'électrodes métalliques afin que cet empilement de couches soit gravé ultérieurement pour former des composants fonctionnels piézoélectriques et/ou pyroélectriques et/ou ferroélectriques et/ou diélectriques réalisés à partir des couches transférées sur le deuxième substrat 106.

Dans les modes et exemples de réalisation précédemment décrits, le deuxième substrat 106 sur lequel au moins une couche de matériau est reportée correspond à une couche de matériau non structurée. En variante, il est possible que des cavités soient réalisées à travers au moins une partie de l'épaisseur du deuxième substrat 106, depuis la face arrière de ce deuxième substrat 106, afin que la ou les couches transférées puissent être utilisées pour former des membranes des dispositifs réalisés à partir de la ou des couches transférées.

De plus, il est possible que la couche de matériau reportée soit structurée et fasse partie d'un ou plusieurs composants fonctionnels déjà réalisés avant le transfert sur le deuxième substrat 106.

Selon une autre variante, il est possible que des couches supplémentaires à celles décrites dans les précédents modes de réalisation soient présentes sur le deuxième substrat 106 avant sa solidarisation avec le premier substrat 104. Par exemple, lorsque la ou les couches reportées sur le deuxième substrat 106 sont destinées à la réalisation de composants de type capacités RF, il est possible qu'une ou plusieurs couches métalliques ayant une faible résistivité (comprenant par exemple de l'or) soient présentes sur le deuxième substrat 106. Cette variante est particulièrement avantageuse lorsque les couches reportées sur le deuxième substrat 106 incluent une couche comprenant un matériau diélectrique « high-k » (ou à forte permittivité, par exemple supérieure à environ 3,4, et comprenant par exemple du BST (Ba_{1-X}Sr_{X}TiO₃) ou du BCTZ (Ba(Ti_{0.8}Zr_{0.2})O₃ - (Ba_{0.7}Ca_{0.3})TiO₃), car un tel matériau diélectrique est très complexe à réaliser sur une couche métallique de faible résistivité.

Le procédé de transfert décrit ici peut avantageusement servir à la réalisation de composants formant des transducteurs électromécaniques intégrant des matériaux qui vont permettre de réaliser des fonctions d'actionneur et/ou de capteur. La fonction capteur est obtenue par l'effet piézoélectrique direct (une contrainte mécanique entraîne l'apparition de charges électriques dans le matériau) tandis que la fonction actionneur est obtenue par effet piézoélectrique inverse (dans ce cas une polarisation électrique externe au matériau entraîne une déformation mécanique de ce dernier).

Pour réaliser la fonction actionneur, un matériau piézoélectrique présentant un coefficient piézoélectrique transverse de coefficient d31 le plus élevé possible est généralement choisi. C'est le cas du PZT (ou du PZT dopé (La, Mn, Nb), du KNN, du BNT-BT, ou encore du PMN-PT).

Pour réaliser la fonction capteur, un matériau présentant le meilleur compromis entre un fort coefficient piézoélectrique transverse e31 et une faible permittivité diélectrique εᵣ, c'est-à-dire avec la plus grande Figure de Mérite FOM= e31/εᵣ, est généralement choisi. C'est le cas typiquement de l'AIN (ou encore de l'AIN dopé Sc).

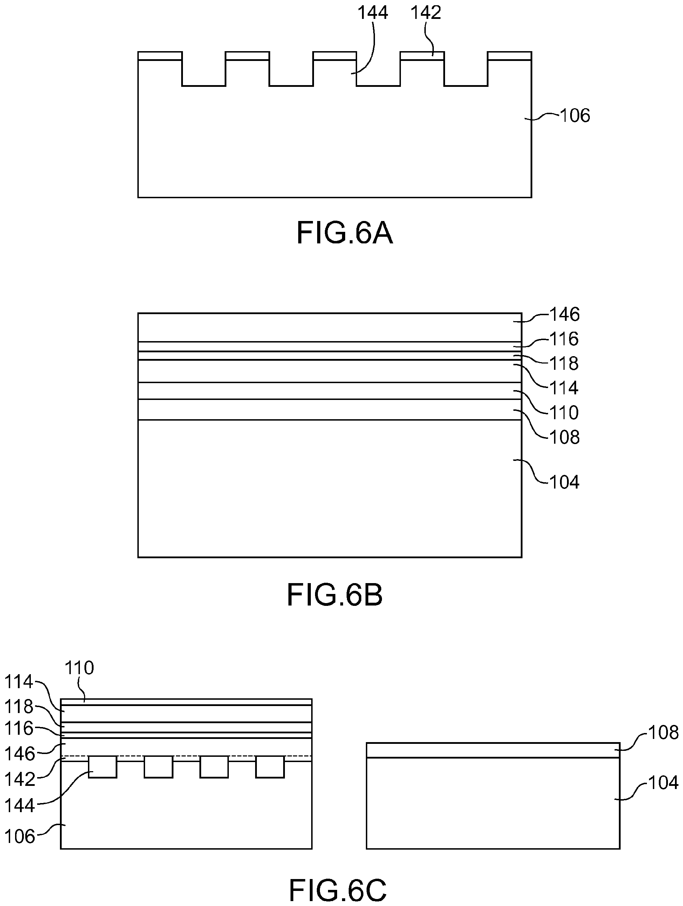

Le procédé de transfert de couche(e) décrit ici peut s'appliquer avantageusement à la réalisation d'une telle structure de transduction électromécanique. Un cinquième mode de réalisation du procédé de transfert est décrit ci-dessous en lien avec les figures 6A à 6C, par exemple pour la réalisation d'un PMUT ou d'un système de récupération d'énergie.

Le deuxième substrat 106 est tout d'abord préparé pour recevoir la ou les couches à transférer depuis le premier substrat 104. Dans l'exemple décrit ici, les premier et deuxième substrats 104, 106 sont destinés à être solidarisés l'un à l'autre par collage direct, ou collage moléculaire. Ainsi, une première couche de collage direct 142 adaptée pour un tel collage direct est formée sur la face du deuxième substrat 106 se trouvant du côté où la ou les couches seront transférées. Des cavités 144 sont ensuite réalisées à travers la première couche de collage direct 142 et une partie de l'épaisseur du deuxième substrat 106 (voir figure 6A). Ces cavités 144 sont destinées à se trouver sous les membranes des structures de transduction électromécanique qui seront réalisées ensuite à partir des couches qui seront transférées sur le deuxième substrat 106.

Les couches à transférer sont réalisées sur le premier substrat 104. Comme dans les précédents modes de réalisation, l'interface de faible force d'adhérence est formée par les couches de séparation 108, 110 sur lesquelles se trouvent la couche 114 qui comporte ici un matériau piézoélectrique et/ou pyroélectrique et/ou ferroélectrique et/ou diélectrique, la couche d'accroche 116 comprenant par exemple du TiO₂, la couche d'électrode 118 qui comporte par exemple du platine et qui est destinée à former une des électrodes des éléments de transduction électromécanique (l'autre électrode étant destinée à être formée par la deuxième couche de séparation 110), et une deuxième couche de collage direct 146 adaptée pour la mise en oeuvre d'un collage direct avec l'autre couche de collage direct 142.

Les couches de collage direct 142, 146 comportent par exemple du SiO2, ou du SiN, ou du Si, et ont par exemple une épaisseur comprise entre environ 1 nm et 100 µm.

Les deux substrats 104, 106 sont ensuite solidarisés l'un à l'autre par collage direct entre les couches de collage direct 142, 146, puis une séparation mécanique est réalisée au niveau de l'interface de faible force d'adhérence formée entre les couches de séparation 108, 110. Les deux substrats 104, 106 séparés, avec les différentes couches transférées sur le deuxième substrat 106, sont représentés sur la figure 6C. Les couches 142, 146 collées l'une à l'autre servent ensuite pour former les membranes sur lesquelles les éléments de transduction électromécanique sont réalisés à partir des couches 114, 110 et 136.

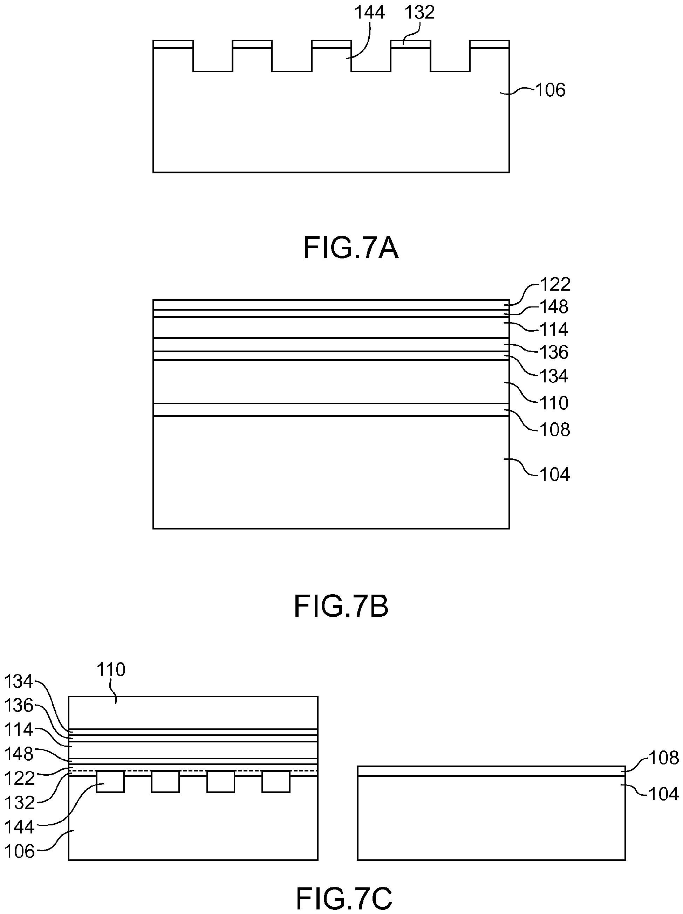

Selon une variante de ce cinquième mode de réalisation, la solidarisation entre les substrats 104, 106 peut être réalisée par thermocompression en utilisant des couches métalliques de collage 122, 132 entre les substrats 104, 106, comme précédemment décrit en lien avec les figures 2A-2B et 3A-3C. Dans ce cas, il est possible de ne pas réaliser la couche d'électrode 118, et la couche de collage métallique obtenue par la mise en oeuvre de la thermocompression peut être destinée à former l'une des électrodes des éléments de transduction électromécanique. Une telle variante est décrite ci-dessous en lien avec les figures 7A à 7C.

Le deuxième substrat 106 est tout d'abord préparé pour recevoir la ou les couches à transférer depuis le premier substrat 104. Une couche métallique de collage 132 est formée sur la face du deuxième substrat 106 se trouvant du côté où la ou les couches seront transférées. Dans l'exemple de réalisation décrit ici, la couche métallique de collage 132 comporte de l'or ou du cuivre. Des cavités 144 sont ensuite réalisées à travers la couche métallique de collage 132 et une partie de l'épaisseur du deuxième substrat 106 (voir figure 7A).

Les couches à transférer sont réalisées sur le premier substrat 104. Comme dans les précédents modes de réalisation, l'interface de faible force d'adhérence est formée par les couches de séparation 108, 110. Sur l'exemple de réalisation représenté sur la figure 7B, la première couche de séparation 108 comporte du platine et la deuxième couche de séparation 110 comporte du SiO₂. Dans cette variante, la deuxième couche de séparation 110 n'est pas destinée à servir d'électrode et a une épaisseur par exemple comprise entre environ 1 nm et 20 µm et est destinée à former une membrane élastique des dispositifs réalisés par la suite à partir de l'empilement de couches transférées sur le deuxième substrat 106. En variante, si les dispositifs à réaliser ne sont pas destinés à avoir de membrane élastique, la deuxième couche de séparation 110 peut être gravée après le transfert sur le deuxième substrat 106.

Une couche d'accroche 134 comprenant par exemple du TiO₂ est réalisée sur la deuxième couche de séparation 110. Une couche d'électrode 136 comprenant par exemple du platine et qui est destinée à former une électrode des éléments de transduction électromécanique réalisés ultérieurement est formée sur la couche d'accroche 134. La couche 114 de matériau piézoélectrique et/ou pyroélectrique et/ou ferroélectrique et/ou diélectrique, une autre couche d'accroche 148 (d'épaisseur par exemple comprise entre environ 5 nm et 10 nm et comprenant du W et/ou du TiN et/ou du Cr et/ou du Ru) et l'autre couche métallique de collage 122, comprenant par exemple de l'or ou du cuivre, sont formées sur la couche d'électrode 136 (figure 7B).

Les deux substrats 104, 106 sont ensuite solidarisés l'un à l'autre par thermocompression entre les couches métalliques de collage 122, 132, puis une séparation est réalisée au niveau de l'interface des couches de séparation 108, 110. Les deux substrats 104, 106 séparés, avec les différentes couches transférées sur le deuxième substrat 106, sont représentés sur la figure 7C. Les éléments de transduction électromécanique sont ensuite réalisés à partir des couches transférées sur le deuxième substrat 106. Dans la structure obtenue, les couches métalliques de collage 122, 132 forment ensemble l'électrode inférieure de chacune des éléments de transduction électromécanique.

Selon une variante de l'exemple précédemment décrit, la deuxième couche de séparation 110 destinée à faire partie des membranes des éléments de transduction électromécanique peut être remplacée par un empilement comprenant la deuxième couche de séparation 108 (d'épaisseur moins importante que dans l'exemple précédent), une couche de semi-conducteur, par exemple de silicium, et une autre couche d'oxyde de semi-conducteur, par exemple du SiO₂. Ces couches peuvent notamment former un empilement SiOz - Si - SiO₂ destiné à faire partie des membranes des éléments de transduction électromécanique, et dont les épaisseurs de ces couches sont choisies pour ajuster la contrainte globale de ces membranes.

Les différents exemples et variantes précédemment décrits peuvent s'appliquer aux exemples de réalisation décrits ci-dessus dans lesquels les cavités 144 sont réalisées dans le deuxième substrat 106.

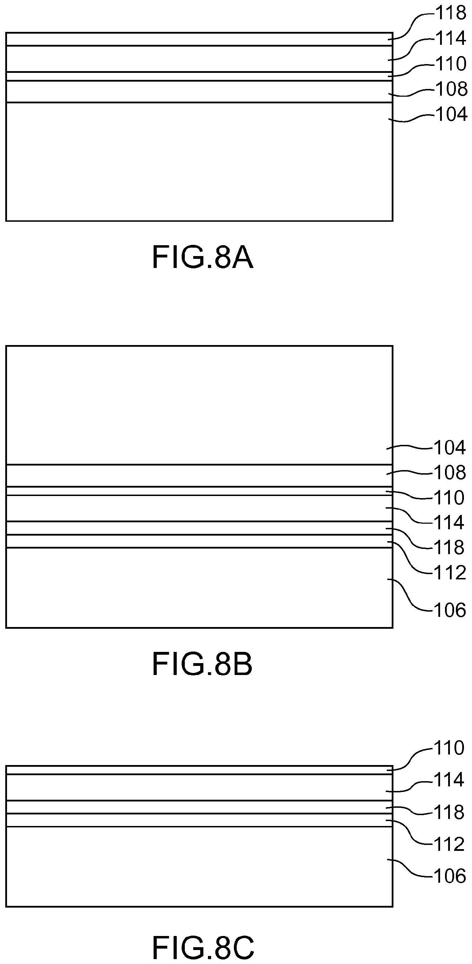

Le procédé de transfert de couche(e) décrit ici peut s'appliquer avantageusement à la réalisation de capacités ou condensateurs de type MIM. Un tel procédé de transfert selon un sixième mode de réalisation est décrit ci-dessous en lien avec les figures 8A à 8C.

Les couches à transférer sont réalisées sur le premier substrat 104, par exemple en silicium. Comme dans les précédents modes de réalisation, l'interface de faible force d'adhérence est formée par les couches de séparation 108, 110. La première couche de séparation 108 comprenant le SiO₂ est disposée entre la deuxième couche de séparation 110 comprenant le métal noble, ici le platine, et le premier substrat 104, afin que la deuxième couche de séparation 110 puisse servir à former ultérieurement l'une des électrodes de chacune des capacités ou condensateurs qui seront réalisés à partir des couches transférées sur le deuxième substrat 106. La couche 114, qui comporte ici un matériau diélectrique, est réalisée sur la deuxième couche de séparation 110, puis la couche d'électrode 118 est réalisée sur la couche 114. Un large choix de matériaux est disponible pour former la couche d'électrode 118, comme par exemple du Pt, du Ru, du RuOz, de l'Ir, de l'Au, du Cu, etc. La couche 114 peut comporter par exemple un matériau diélectrique ou bien un matériau piézoélectrique et/ou ferroélectrique et/ou pyroélectrique, selon le dispositif destiné à être réalisé (condensateur, transducteur, etc.).

Le premier substrat 104 et les couches réalisées sur celui-ci sont transférés sur le deuxième substrat 106 qui correspond ici à un substrat comportant au moins un matériau polymère par l'intermédiaire de la couche adhésive 112 (figure 8B). Un support rigide peut être disposé sous le deuxième substrat 106 pour faciliter la mise en oeuvre de ce collage.

Une séparation est ensuite réalisée au niveau de l'interface des couches de séparation 108, 110. Le deuxième substrat 106 avec les différentes couches transférées sur celui-ci est représenté sur la figure 8C.

Dans ce sixième mode de réalisation, la deuxième couche de transfert 110 est destinée à former l'électrode supérieure des capacités ou condensateurs qui seront réalisés à partir des couches transférées sur le deuxième substrat 106. En variante, il est possible de graver la deuxième couche de transfert 110 pour la remplacer par un autre matériau d'électrode déposé sur la couche 114.

Un tel sixième mode de réalisation peut servir à réaliser des condensateurs, par exemple de découplage, des transducteurs (actionneur et/ou capteur), des dispositifs de récupération d'énergie vibratoire, ou encore des mémoires ferroélectriques.

Selon une variante, il est possible de ne pas réaliser la couche d'électrode 118. Dans ce cas, la couche 114 est directement disposée sur la couche adhésive 112. Une telle variante est par exemple mise en oeuvre pour réaliser des capacités coplanaires, obtenue en gravant ensuite la couche d'électrode supérieure (couche 110) pour former les électrodes de ces capacités qui se trouve sur une seule face (face supérieure sur la figure 8C) de la couche 114.

Selon une variante, la solidarisation entre les premier et deuxième substrats 104, 106 peut être réalisée par collage par thermocompression en formant les couches métalliques de collage 122, 132. Dans ce cas, ces couches métalliques de collage 122, 132 peuvent former ensemble l'une des électrodes des capacités réalisées à partir des couches transférées sur le deuxième substrat 106. Une couche d'accroche peut être formée sur la couche 114 préalablement au dépôt de la première couche métallique de collage 122. De même, une autre couche d'accroche peut être réalisée sur le deuxième substrat 106 préalablement au dépôt de la deuxième couche métallique de collage 132. Ces couches d'accroche peuvent dans ce cas faire partie de l'électrode qui sera formée par les couches métalliques de collage 122, 132.

Selon une autre variante, un collage direct peut être mis en oeuvre entre des couches de collage direct 142, 146 comme précédemment décrit.

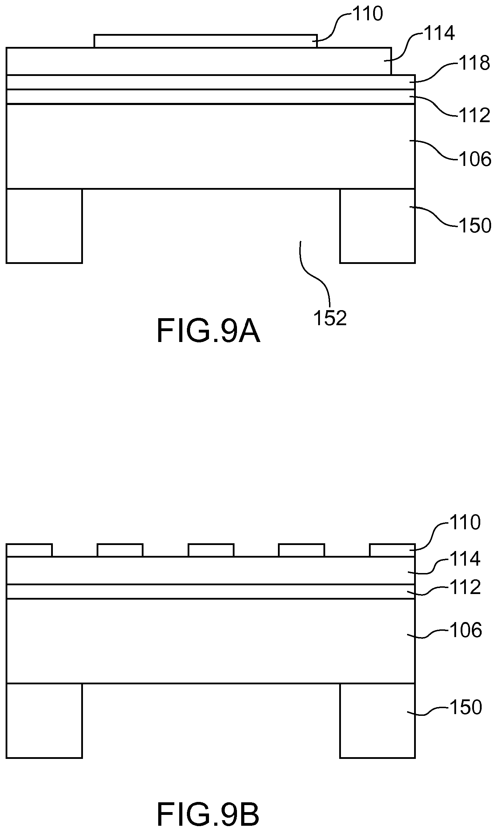

Selon une autre variante, le deuxième substrat 106 peut servir de membranes souples aux dispositifs réalisés à partir des couches transférées. Dans ce cas, le deuxième substrat 106 est disposé sur un support mécanique 150 qui peut être gravé depuis sa face arrière pour libérer la membrane via la création d'une cavité 152 sous la membrane. La figure 9A représente une capacité MIM d'un dispositif transducteur piézoélectrique dans lequel le deuxième substrat 106 forme une membrane souple / flexible de cette capacité. La figure 9B représente une capacité coplanaire d'un tel dispositif dans lequel la deuxième couche de séparation 110 est gravée telle que les portions restantes de cette couche forment les électrodes de la capacité (sur la figure 9B, aucune électrode inférieure n'est présente entre la couche 114 et le deuxième substrat 106).

Dans les modes et exemples de réalisation décrits ci-dessus, une seule couche de matériau piézoélectrique 114 est utilisée. En variante, le procédé de transfert peut être mis en oeuvre pour former sur le deuxième substrat 106 un l'empilement de couches comportant deux couches piézoélectriques superposées, l'une de ces deux couches ayant avantageusement un matériau piézoélectrique adapté pour réaliser un actionnement piézoélectrique, c'est-à-dire présentant un coefficient piézoélectrique transverse d31 le plus élevé possible, comme par exemple du PZT, ou du PZT dopé La, Mn ou Nb, ou du KNN, ou du BNT-BT, ou du PMN-PT, et l'autre de ces deux couches ayant un matériau piézoélectrique adapté pour réaliser la fonction capteur, c'est-à-dire présentant le meilleur compromis entre un fort coefficient piézoélectrique transverse e31 et une faible permittivité diélectrique, comme par exemple de l'AIN ou de l'AIN dopé Sc. Pour cela, chacune de ces couches piézoélectriques est réalisée sur l'un des deux substrats 104, 106.

En effet, certains dispositifs MEMS / NEMS piézoélectriques fonctionnent à la fois en mode actionneur et en mode capteur. C'est le cas des PMUT (Transducteurs Ultrasonores Micro-usinés Piézoélectriques). Ils fonctionnent en actionneur pour émettre des ondes acoustiques (émission) et en capteur pour réceptionner les ondes acoustiques en retour (réception). Les dispositifs PMUT intègrent un même matériau piézoélectrique qui va permettre à la fois l'émission d'ondes ultrasonores (US) et la réception des ondes US en retour. Les transducteurs électromécaniques comportent très souvent sous forme de membrane type peau de tambour, c'est-à-dire une membrane (couche élastique + couche dite « motrice » (piézoélectrique ou autre)) suspendue au-dessus d'une cavité.

Le procédé de transfert proposé ici est avantageux car un tel empilement de deux matériaux piézoélectriques différents est difficile à obtenir avec les procédés classiques de l'art antérieur, en raison des contraintes technologiques telles que le budget thermique, la diffusion des éléments lors des recuits qui nécessite l'ajout de couches barrières, une croissance cristalline délicate, la gestion des contraintes mécaniques, etc. Lorsque deux couches de matériaux piézoélectriques sont réalisées, il n'est pas nécessaire de former une membrane élastique ou mécanique à base de Si, de SiOz ou de SiN car en fonctionnement actionneur, le matériau piézoélectrique servant de capteur joue le rôle de membrane élastique et en fonctionnement capteur, le matériau piézoélectrique servant d'actionneur joue le rôle de membrane élastique.

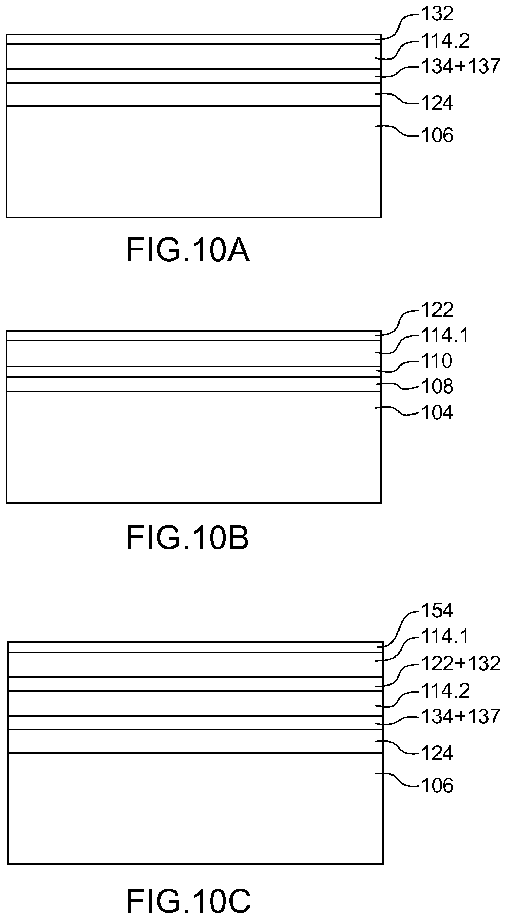

Un tel procédé de transfert mis en oeuvre pour réaliser un empilement comprenant deux couches de matériaux piézoélectriques est décrit ci-dessous et en lien avec les figures 10A à 10F.

Comme représenté sur la figure 10A, une partie de l'empilement, correspondant à la partie actionneur, est formée sur le deuxième substrat 106. Cette partie de l'empilement comporte la couche d'isolation 124, la couche d'accroche 134, la couche d'électrode 136, la deuxième couche piézoélectrique 114.2 qui comporte par exemple du PZT, et la deuxième couche métallique de collage 132.

L'autre partie de l'empilement, correspondant à la partie capteur, est réalisée sur le premier substrat 104. Cette autre partie de l'empilement comporte les première et deuxième couches de séparation 108, 110, la première couche piézoélectrique 114.1 qui comporte par exemple de l'AIN, et l'autre couche métallique de collage 122 (figure 10B).

Les premier et deuxième substrats 104, 106 sont solidarisés l'un à l'autre par un collage par thermocompression mis en oeuvre entre les couches métalliques de collage 122, 132.

Une séparation mécanique est ensuite réalisée entre les couches de séparation 108, 110. La deuxième couche de séparation 110 restante sur la première couche piézoélectrique 114.1 est supprimée, puis une nouvelle couche d'électrode 154, comprenant par exemple du Mo est formée sur la première couche piézoélectrique 114.1 (figure 10C). Dans la structure ainsi obtenue, les couches 154 et 136 ainsi que les couches métalliques de collage 122, 132 forment les électrodes (les couches métalliques de collage forment une électrode commune utilisée à la fois par la partie capteur et par la partie actionneur des dispositifs).

Des couches d'accroche et/ou des couches formant des barrières de diffusion (pour bloquer par exemple la diffusion de l'or provenant des couches métalliques de collage) peuvent être disposées entre les deux métalliques de collage 122, 132 et les couches de matériau piézoélectrique 114.1, 114.2.

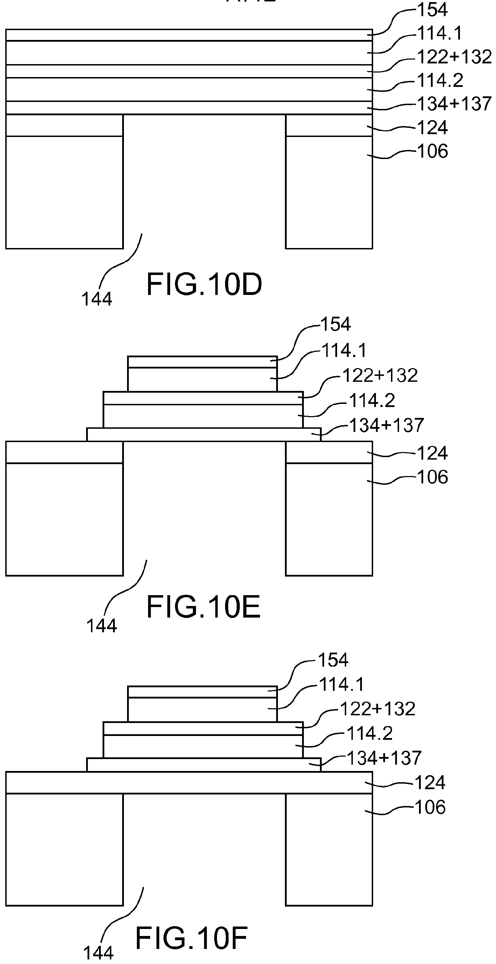

Le deuxième substrat 106 et la couche 124 sont ensuite gravés depuis la face arrière du deuxième substrat 102, formant les cavités 144 (une seule cavité 144 est représentée sur la figure 10D) sous les parties de l'empilement destinées à former les membranes des dispositifs. Les autres couches de l'empilement sont ensuite gravées suivant la configuration souhaitée pour les dispositifs (voir figure 10E).

En variante, il est possible que les cavités 144 ne soient pas formées à travers la couche 124, comme c'est le cas sur l'exemple de la figure 10F. La couche 124 forme alors une couche d'arrêt de gravure lors de la réalisation des cavités 144 et peut également servir de couche élastique du ou des dispositifs réalisés ensuite.

Selon une autre variante, avant la solidarisation des deux substrats 104, 106, la partie de l'empilement correspondant à la partie capteur (incluant la couche piézoélectrique 114.2) peut être réalisée sur le deuxième substrat 106 et la partie de l'empilement correspondant à la partie actionneur (incluant la couche piézoélectrique 114.2) peut être réalisée sur le premier substrat 104. Dans ce cas, l'électrode formée entre le deuxième substrat 106 et la couche piézoélectrique 114.1 peut comporter du molybdène formée sur une couche de croissance présente sur la couche d'isolation 124.

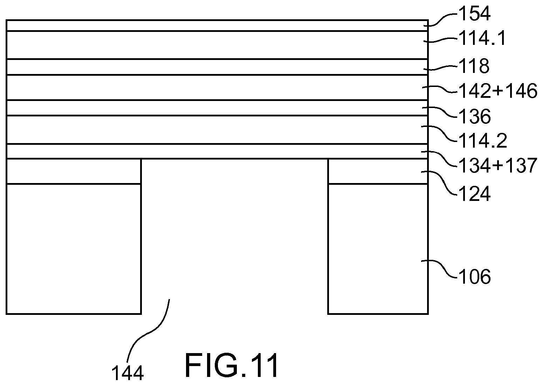

Selon une autre variante, les deux parties de l'empilement réalisées sur les deux substrats 104, 106 peuvent être solidarisées l'une à l'autre par l'intermédiaire d'un collage direct. L'empilement obtenu à l'issue d'une telle solidarisation est représenté par exemple sur la figure 11. La couche 142+146 issue du collage direct peut servir de couche élastique du ou des dispositifs réalisés ensuite.

Les différents exemples de réalisation et les différentes variantes de réalisation décrits peuvent s'appliquer pour chacun des modes de réalisation.

## Revendications

1. Procédé de transfert d'au moins une couche de matériau (102) depuis un premier substrat (104) sur un deuxième substrat (106), comportant au moins :
- réalisation, sur une face du premier substrat (104), de première et deuxième couches de séparation (108, 110) disposées l'une contre l'autre et telles que la première couche de séparation (108) soit disposée entre le premier substrat (104) et la deuxième couche de séparation (110) ;
- réalisation, sur la deuxième couche de séparation (110), de ladite au moins une couche de matériau à transférer (102) ;
- solidarisation de ladite au moins une couche de matériau à transférer (102) au deuxième substrat (106), formant un empilement de différents matériaux ;
- séparation mécanique au niveau d'une interface entre les première et deuxième couches de séparation (108, 110), telle que la première couche de séparation (108) reste solidaire du premier substrat (104) et que la deuxième couche de séparation (110) reste solidaire de ladite au moins une couche de matériau à transférer (102) ;
dans lequel les matériaux de l'empilement sont choisis tels que l'interface entre les première et deuxième couches de séparation (108, 110) correspond à celle, parmi toutes les interfaces de l'empilement, ayant la plus faible force d'adhérence, et dans lequel le procédé comporte, entre l'étape de réalisation des première et deuxième couches de séparation (108, 110) et l'étape de solidarisation, la mise en oeuvre d'au moins une étape réduisant une force d'adhérence initiale de l'interface entre les première et deuxième couches de séparation (108, 110).

2. Procédé selon la revendication 1, dans lequel l'une des première et deuxième couches de séparation (108, 110) comporte au moins du SiOz et/ou du nitrure de silicium et l'autre des première et deuxième couches de séparation (108, 110) comporte au moins un métal noble.

3. Procédé selon la revendication 2, dans lequel le métal noble comporte du platine.

4. Procédé selon l'une des revendications 2 ou 3, dans lequel ladite au moins une étape réduisant la force d'adhérence initiale de l'interface entre les première et deuxième couches de séparation (108, 110) comporte la mise en oeuvre d'au moins un traitement thermique à une température modifiant une contrainte du métal noble.

5. Procédé selon l'une des revendications précédentes, dans lequel l'étape de la solidarisation est mise en oeuvre :
- par l'intermédiaire d'une couche adhésive (112) réalisée sur ladite au moins une couche de matériau à transférer (102) ou sur le deuxième substrat (106), ou
- par thermocompression entre une première couche métallique de collage (122), réalisée sur ladite au moins une couche de matériau à transférer (102), et une deuxième couche métallique de collage (132) réalisée sur le deuxième substrat (106), ou
- par collage direct entre une première couche de collage (142), réalisée sur ladite au moins une couche de matériau à transférer (102), et une deuxième couche de collage (146) réalisée sur le deuxième substrat (106).

6. Procédé selon l'une des revendications précédentes, dans lequel ladite au moins une couche de matériau à transférer (102) comporte au moins une couche (114) de matériau pyroélectrique et/ou piézoélectrique et/ou ferroélectrique et/ou diélectrique.

7. Procédé selon la revendication 6, dans lequel :
- le matériau pyroélectrique et/ou piézoélectrique et/ou ferroélectrique et/ou diélectrique comporte du plomb ;
- ladite une des première et deuxième couches de séparation (108, 110) comporte du SiO₂;
- ladite au moins une étape réduisant la force d'adhérence initiale de l'interface entre les première et deuxième couches de séparation (108, 110) comporte la mise en oeuvre d'au moins un traitement thermique formant, à l'interface entre les première et deuxième couches de séparation (108, 110), un alliage de plomb et de SiO₂ en phase liquide, puis d'un refroidissement formant des cavités (138) à l'interface entre les première et deuxième couches de séparation (108, 110).

8. Procédé selon l'une des revendications 6 ou 7, dans lequel ladite au moins une couche de matériau à transférer (102) comporte au moins une première couche d'électrode (118) telles que la couche (114) de matériau pyroélectrique et/ou piézoélectrique et/ou ferroélectrique et/ou diélectrique soit disposée entre la première couche électriquement conductrice (118) et la deuxième couche de séparation (110).

9. Procédé selon l'une des revendications 6 à 8, dans lequel la deuxième couche de séparation (110) comporte au moins un métal noble.

10. Procédé selon l'une des revendications 6 à 9, dans lequel ladite au moins une couche de matériau à transférer comporte au moins une deuxième couche d'électrode (136) disposée entre la couche (114) de matériau pyroélectrique et/ou piézoélectrique et/ou ferroélectrique et/ou diélectrique et la deuxième couche de séparation (110).

11. Procédé selon l'une des revendications 1 à 5, dans lequel ladite au moins une couche de matériau à transférer (102) comporte au moins une première couche (114.1) de matériau pyroélectrique et/ou piézoélectrique et/ou ferroélectrique et/ou diélectrique, et comprenant en outre, avant l'étape de solidarisation, la réalisation d'au moins une deuxième couche (114.2) de matériau pyroélectrique et/ou piézoélectrique et/ou ferroélectrique et/ou diélectrique et d'au moins une troisième couche d'électrode (137) disposée entre le deuxième substrat (106) et la deuxième couche (114.2) de matériau pyroélectrique et/ou piézoélectrique et/ou ferroélectrique et/ou diélectrique.

12. Procédé selon l'une des revendications 6 à 11, comprenant en outre :
- avant l'étape de solidarisation, la réalisation de cavités (144) dans le deuxième substrat (106), à travers une face du deuxième substrat (106) sur laquelle ladite au moins une couche de matériau à transférer (102) est solidarisée, et/ou
- après l'étape de solidarisation, la réalisation de cavités (152) dans le deuxième substrat (106), à travers une face opposée à celle sur laquelle ladite au moins une couche de matériau à transférer (102) est solidarisée.

13. Procédé selon l'une des revendications 1 à 11, dans lequel le deuxième substrat (106) comporte au moins un matériau polymère, et dans lequel l'étape de solidarisation est mise en oeuvre à une température inférieure ou égale à environ 150°C.

14. Procédé selon l'une des revendications précédentes, comprenant en outre, après l'étape de séparation mécanique, une étape de gravure de la deuxième couche de séparation (110).

15. Procédé selon l'une des revendications précédentes, comportant en outre, entre l'étape de réalisation de ladite au moins une couche de matériau à transférer (102) et l'étape de solidarisation de ladite au moins une couche de matériau à transférer (102) au deuxième substrat (106), une étape de réalisation de composants fonctionnels de type MEMS et/ou NEMS et/ou microélectroniques à partir de ladite au moins une couche de matériau à transférer (102).

16. Procédé selon l'une des revendications précédentes, dans lequel, après l'étape de séparation mécanique, les précédentes étapes du procédé de transfert sont chacune répétées au moins une fois pour transférer au moins une autre couche de matériau depuis le premier substrat sur ladite au moins une couche de matériau (102).

17. Procédé de réalisation de composants de type MEMS et/ou NEMS et/ou microélectroniques, comprenant la mise en oeuvre d'un procédé de transfert selon l'une des revendications précédentes, puis la réalisation des composants à partir du deuxième substrat (106) et de ladite au moins une couche de matériau à transférer (102).

18. Procédé selon la revendication 17, dans lequel les composants réalisés sont des transducteurs piézoélectriques et/ou des composants pyroélectriques et/ou ferroélectriques et/ou comportent des condensateurs de type MIM et/ou coplanaires, et dans lequel le procédé de transfert mis en oeuvre correspond au procédé de transfert selon l'une des revendications 6 à 12.

## Patentansprüche

1. Verfahren zum Übertragen mindestens einer Materialschicht (102) von einem ersten Substrat (104) auf ein zweites Substrat (106), das mindestens Folgendes umfasst:
- Herstellen einer ersten und einer zweiten Trennschicht (108, 110), die einander gegenüber auf einer Fläche des ersten Substrats (104) angeordnet sind, und zwar so, dass die erste Trennschicht (108) zwischen dem ersten Substrat (104) und der zweiten Trennschicht (110) angeordnet ist;
- Herstellen der mindestens einen Schicht (102) aus dem zu übertragenden Material auf der zweiten Trennschicht (110);
- Befestigen der mindestens einen Schicht (102) aus dem zu übertragenden Material auf dem zweiten Substrat (106), wodurch ein Stapel aus verschiedenen Materialien gebildet wird;
- mechanisches Trennen an einer Grenzfläche zwischen der ersten und der zweiten Trennschicht (108, 110), so dass die erste Trennschicht (108) mit dem ersten Substrat (104) befestigt bleibt und dass die zweite Trennschicht (110) mit der mindestens einen Schicht (102) aus dem zu übertragenden Material befestigt bleibt;
wobei die Materialien des Stapels so ausgewählt sind, dass die Grenzfläche zwischen der ersten und der zweiten Trennschicht (108, 110) derjenigen aus allen Grenzflächen des Stapels entspricht, die die geringste Haftkraft aufweist, und wobei das Verfahren zwischen dem Schritt des Herstellens der ersten und der zweiten Trennschicht (108, 110) und dem Schritt des Befestigens das Durchführen von mindestens einem Schritt des Reduzierens einer anfänglichen Haftkraft der Grenzfläche zwischen der ersten und der zweiten Trennschicht (108, 110) umfasst.

2. Verfahren nach Anspruch 1, wobei eine der ersten und der zweiten Trennschicht (108, 110) mindestens eines von SiO₂ und/oder Siliziumnitrid umfasst und die andere der ersten und der zweiten Trennschicht (108, 110) mindestens ein Edelmetall umfasst.

3. Verfahren nach Anspruch 2, wobei das Edelmetall Platin umfasst.

4. Verfahren nach einem der Ansprüche 2 oder 3, wobei der mindestens eine Schritt des Reduzierens der anfänglichen Haftkraft der Grenzfläche zwischen der ersten und der zweiten Trennschicht (108, 110) das Durchführen mindestens einer Wärmebehandlung bei einer Temperatur umfasst, die eine Spannung des Edelmetalls modifiziert.

5. Verfahren nach einem der vorhergehenden Ansprüche, wobei der Schritt des Befestigens wie folgt durchgeführt wird:
- durch eine Haftschicht (112), die auf der mindestens einen Schicht (102) aus dem zu übertragenden Material oder auf dem zweiten Substrat (106) hergestellt wird, oder
- durch Thermokompression zwischen einer ersten Metallklebeschicht (122), die auf der mindestens einen Schicht (102) aus dem zu übertragenden Material hergestellt wird, und einer zweiten Metallklebeschicht (132), die auf dem zweiten Substrat (106) hergestellt wird, oder
- durch direktes Verkleben zwischen einer ersten Klebeschicht (142), die auf der mindestens einen Schicht (102) aus dem zu übertragenden Material hergestellt wird, und einer zweiten Klebeschicht (146), die auf dem zweiten Substrat (106) hergestellt wird.

6. Verfahren nach einem der vorhergehenden Ansprüche, wobei die mindestens eine Schicht (102) aus dem zu übertragenden Material mindestens eine Schicht (114) aus einem pyroelektrischen und/oder piezoelektrischen und/oder ferroelektrischen und/oder dielektrischen Material umfasst.

7. Verfahren nach Anspruch 6, wobei:
- das pyroelektrische und/oder piezoelektrische und/oder ferroelektrische und/oder dielektrische Material Blei umfasst;
- die eine der ersten und der zweiten Trennschicht (108, 110) SiO₂ umfasst;
- der mindestens eine Schritt des Reduzierens der anfänglichen Haftkraft der Grenzfläche zwischen der ersten und der zweiten Trennschicht (108, 110) das Durchführen mindestens einer Wärmebehandlung, bei der an der Grenzfläche zwischen der ersten und der zweiten Trennschicht (108, 110) eine Legierung aus Blei und SiO₂ in flüssiger Phase gebildet wird, und dann eines Abkühlens umfasst, bei dem die Hohlräume (138) an der Grenzfläche zwischen der ersten und der zweiten Trennschicht (108, 110) gebildet werden.

8. Verfahren nach einem der Ansprüche 6 oder 7, wobei die mindestens eine Schicht (102) aus dem zu übertragenden Material mindestens eine erste Elektrodenschicht (118) umfasst, so dass die Schicht (114) aus dem pyroelektrischen und/oder piezoelektrischen und/oder ferroelektrischen und/oder dielektrischen Material zwischen der ersten elektrisch leitenden Schicht (118) und der zweiten Trennschicht (110) angeordnet ist.

9. Verfahren nach einem der Ansprüche 6 bis 8, wobei die zweite Trennschicht (110) mindestens ein Edelmetall umfasst.

10. Verfahren nach einem der Ansprüche 6 bis 9, wobei die mindestens eine Schicht aus dem zu übertragenden Material mindestens eine zweite Elektrodenschicht (136) umfasst, die zwischen der Schicht (114) aus dem pyroelektrischen und/oder piezoelektrischen und/oder ferroelektrischen und/oder dielektrischen Material und der zweiten Trennschicht (110) angeordnet ist.

11. Verfahren nach einem der Ansprüche 1 bis 5, wobei die mindestens eine Schicht (102) aus dem zu übertragenden Material mindestens eine erste Schicht (114.1) aus einem pyroelektrischen und/oder piezoelektrischen und/oder ferroelektrischen und/oder dielektrischen Material umfasst und ferner vor dem Schritt des Befestigens das Herstellen mindestens einer zweiten Schicht (114.2) aus einem pyroelektrischen und/oder piezoelektrischen und/oder ferroelektrischen und/oder dielektrischen Material und mindestens einer dritten Elektrodenschicht (137), die zwischen dem zweiten Substrat (106) und der zweiten Schicht (114.2) aus dem pyroelektrischen und/oder piezoelektrischen und/oder ferroelektrischen und/oder dielektrischen Material angeordnet ist, umfasst.

12. Verfahren nach einem der Ansprüche 6 bis 11, das ferner Folgendes umfasst:
- vor dem Schritt des Befestigens, Herstellen von Hohlräumen (144) im zweiten Substrat (106) durch eine Fläche des zweiten Substrats (106), auf der die mindestens eine Schicht (102) aus dem zu übertragenden Material befestigt wird;
- nach dem Schritt des Befestigens, Herstellen von Hohlräumen (152) im zweiten Substrat (106) durch eine Fläche, die derjenigen gegenüberliegt, auf der die mindestens eine Schicht (102) aus dem zu übertragenden Material befestigt wird.

13. Verfahren nach einem der Ansprüche 1 bis 11, wobei das zweite Substrat (106) mindestens ein Polymermaterial umfasst, und wobei der Schritt des Befestigens bei einer Temperatur von ungefähr 150 °C oder weniger durchgeführt wird.

14. Verfahren nach einem der vorhergehenden Ansprüche, das ferner nach dem Schritt des mechanischen Trennens einen Schritt des Ätzens der zweiten Trennschicht (110) umfasst.

15. Verfahren nach einem der vorhergehenden Ansprüche, das ferner zwischen dem Schritt des Herstellens der mindestens einen Schicht (102) aus dem zu übertragenden Material und dem Schritt des Befestigens der mindestens einen Schicht (102) aus dem zu übertragenden Material auf dem zweiten Substrat (106) einen Schritt des Herstellens funktioneller MEMS- und/oder NEMS- und/oder mikroelektronischer Komponenten aus der mindestens einen Schicht (102) aus dem zu übertragenden Material umfasst.

16. Verfahren nach einem der vorhergehenden Ansprüche, wobei nach dem Schritt des mechanischen Trennens die vorhergehenden Schritte des Transferverfahrens jeweils mindestens einmal wiederholt werden, um mindestens eine weitere Materialschicht vom ersten Substrat auf die mindestens eine Materialschicht (102) zu übertragen.

17. Verfahren zum Herstellen von MEMS- und/oder NEMS- und/oder mikroelektronischen Komponenten, das das Durchführen eines Transferverfahrens nach einem der vorhergehenden Ansprüche und dann das Herstellen von Komponenten aus dem zweiten Substrat (106) und aus der mindestens einen Schicht (102) aus dem zu übertragenden Material umfasst.

18. Verfahren nach Anspruch 17, wobei die hergestellten Komponenten piezoelektrische Wandler und/oder pyroelektrische und/oder ferroelektrische Komponenten sind und/oder MIM- und/oder koplanare Kondensatoren umfassen, und wobei das durchgeführte Transferverfahren dem Transferverfahren nach einem der Ansprüche 6 bis 12 entspricht.

## Claims

1. Method for transferring at least one layer of material (102) from a first substrate (104) to a second substrate (106), including at least:
- producing first and second separating layers (108, 110) disposed one against the other on a face of the first substrate (104), and such that the first separating layer (108) is disposed between the first substrate (104) and the second separating layer (110);
- producing said at least one layer of material to be transferred (102) on the second separating layer (110);
- securing said at least one layer of material to be transferred (102) to the second substrate (106), forming a stack of different materials;
- performing mechanical separation at an interface between the first and second separating layers (108, 110), such that the first separating layer (108) remains integral with the first substrate (104) and that the second separating layer (110) remains integral with said at least one layer of material to be transferred (102);
wherein the materials of the stack are chosen such that the interface between the first and second separating layers (108, 110) corresponds to the interface, of all of the interfaces of the stack, having the weakest adhesion force, and wherein the method includes, between the step of producing first and second separating layers (108, 110) and the step of securing, the implementation of at least one step reducing an initial adhesion force of the interface between the first and second separating layers (108, 110).

2. Method according to claim 1, wherein one of the first and second separating layers (108, 110) includes at least SiO₂ and/or silicon nitride and the other of the first and second separating layers (108, 110) includes at least one noble metal.

3. Method according to claim 2, wherein the noble metal includes platinum.

4. Method according to one of claims 2 or 3, wherein said at least one step reducing the initial adhesion force of the interface between the first and second separating layers (108, 110) includes the implementation of at least one heat treatment at a temperature modifying a stress of the noble metal.

5. Method according to one of the preceding claims, wherein the step of securing is implemented:
- by means of an adhesive layer (112) produced on said at least one layer of material to be transferred (102) or on the second substrate (106), or
- by thermocompression between a first metal bonding layer (122), produced on said at least one layer of material to be transferred (102), and a second metal bonding layer (132) produced on the second substrate (106), or
- by direct bonding between a first bonding layer (142), produced on said at least one layer of material to be transferred (102), and a second bonding layer (146) produced on the second substrate (106).

6. Method according to one of the preceding claims, wherein said at least one layer of material to be transferred (102) includes at least one layer (114) of pyroelectric and/or piezoelectric and/or ferroelectric and/or dielectric material.

7. Method according to claim 6, wherein:
- the pyroelectric and/or piezoelectric and/or ferroelectric and/or dielectric material includes lead;
- said one of the first and second separating layers (108, 110) includes SiO₂;
- said at least one step reducing the initial adhesion force of the interface between the first and second separating layers (108, 110) includes the implementation of at least one heat treatment forming, at the interface between the first and second separating layers (108, 110), an alloy of lead and SiO₂ in liquid phase, then of a cooling forming cavities (138) at the interface between the first and second separating layers (108, 110).

8. Method according to one of claims 6 or 7, wherein said at least one layer of material to be transferred (102) includes at least one first electrode layer (118) such that the layer (114) of pyroelectric and/or piezoelectric and/or ferroelectric and/or dielectric material is disposed between the first electrically conductive layer (118) and the second separating layer (110).

9. Method according to one of claims 6 to 8, wherein the second separating layer (110) includes at least one noble metal.

10. Method according to one of claims 6 to 9, wherein said at least one layer of material to be transferred includes at least one second electrode layer (136) disposed between the layer (114) of pyroelectric and/or piezoelectric and/or ferroelectric and/or dielectric material and the second separating layer (110).

11. Method according to one of claims 1 to 5, wherein said at least one layer of material to be transferred (102) includes at least one first layer (114.1) of pyroelectric and/or piezoelectric and/or ferroelectric and/or dielectric material, and further comprising, before the step of securing, producing at least one second layer (114.2) of pyroelectric and/or piezoelectric and/or ferroelectric and/or dielectric material and of at least one third electrode layer (137) disposed between the second substrate (106) and the second layer (114.2) of pyroelectric and/or piezoelectric and/or ferroelectric and/or dielectric material.

12. Method according to one of claims 6 to 11, further comprising:
- before the step of securing, producing cavities (144) in the second substrate (106), through a face of the second substrate (106) whereon said at least one layer of material to be transferred (102) is secured, and/or
- after the step of securing, producing cavities (152) in the second substrate (106), through a face opposite to that whereon said at least one layer of material to be transferred (102) is secured.

13. Method according to one of claims 1 to 11, wherein the second substrate (106) includes at least one polymer material, and wherein the step of securing is implemented at a temperature less than or equal to approximately 150°C.

14. Method according to one of the preceding claims, further comprising, after the step of mechanical separation, a step of etching the second separating layer (110).

15. Method according to one of the preceding claims, further including, between the step of producing said at least one layer of material to be transferred (102) and the step of securing said at least one layer of material to be transferred (102) to the second substrate (106), a step of producing functional MEMS and/or NEMS and/or microelectronic type components from said at least one layer of material to be transferred (102).

16. Method according to one of the preceding claims, wherein, after the step of mechanical separation, the preceding steps of the transfer method are each repeated at least once in order to transfer at least one other layer of material from the first substrate to said at least one layer of material (102).

17. Method for producing MEMS and/or NEMS and/or microelectronic type components, comprising the implementation of a transfer method according to one of the preceding claims, then producing components from the second substrate (106) and from said at least one layer of material to be transferred (102).

18. Method according to claim 17, wherein the components produced are piezoelectric transducers and/or pyroelectric and/or ferroelectric components and/or include MIM and/or coplanar type capacitors, and wherein the transfer method implemented corresponds to the transfer method according to one of claims 6 to 12.
